# EUROPEAN PATENT APPLICATION

(11) **EP 4 804 781 A1**
(43) Date of publication of application: **09.09.2026**
(21) Application number: 26150240.5
(22) Date of filing: 05.01.2026
(51) Int. Cl.: H10P 72/00, B05B 3/02, B05B 12/02, G03F 7/16

(54) **SUBSTRATE PROCESSING APPARATUS**

(30) Priority: 07.03.2025 JP 2025036444
(71) Applicant: SCREEN Holdings Co., Ltd., Kyoto-shi, Kyoto 602-8585 (JP)
(72) Inventor: NISHIYAMA, Koji, Kyoto-shi, 602-8585 (JP)
(74) Representative: Kilian Kilian & Partner mbB

(57) **Abstract**

A substrate processing apparatus includes a substrate holder, nozzles, pipes, a nozzle holder, an arm, and an arm drive section. The nozzle holder holds any one nozzle of the nozzles. The arm is coupled to the nozzle holder. The arm drive section moves the arm. The arm drive section moves the nozzle held by the nozzle holder. Each of the nozzles includes a dispensing port and a connection portion. Each of the pipes includes a downstream end portion. Each of the pipes has flexibility. The nozzle held by the nozzle holder is defined as a selection nozzle. The arm drive section moves the dispensing port of the selection nozzle to a processing position. The selection nozzle is rotatable about a rotation axis with respect to the arm. The rotation axis passes through the dispensing port of the selection nozzle.

## Description

### BACKGROUND OF THE INVENTION

### 1. TECHNICAL FIELD

The present invention relates to a substrate processing apparatus that performs processing on a substrate. The substrate is, for example, any of a semiconductor wafer, a liquid crystal display substrate, an organic electroluminescence (OEL) substrate, a flat panel display (FPD) substrate, an optical display substrate, a magnetic disk substrate, an optical disk substrate, a magneto-optical disk substrate, a photomask substrate, and a solar cell substrate.

### 2. DESCRIPTION OF THE RELATED ART

JP 2014-241382 A discloses a substrate processing apparatus. The substrate processing apparatus disclosed in JP 2014-241382 A includes a nozzle, a pipe, and a nozzle conveyance mechanism. The pipe is connected to the nozzle. The pipe is flexible. The nozzle conveyance mechanism moves the nozzle. When the nozzle conveyance mechanism moves the nozzle, the pipe also moves.

### SUMMARY OF THE INVENTION

In the substrate processing apparatus of JP 2014-241382 A, the pipe has a complicated path. For example, the pipe has a plurality of bent portions. For example, when the nozzle moves, the pipe is unnaturally bent.

Therefore, in the substrate processing apparatus of JP 2014-241382 A, a load is applied to the pipe.

Moreover, the substrate processing apparatus of JP 2014-241382 A may include a cableveyor (registered trademark) in order to complicate the path of the pipe. The cableveyor is also referred to as cable carrier. As the pipe moves, the cableveyor rubs against the pipe. For this reason, the cableveyor may damage the pipe. The cableveyor and the pipe may generate particles.

The present invention has been made in view of such circumstances, and an object of the present invention is to provide a substrate processing apparatus that simplifies a path of a pipe.

In order to achieve such an object, the present invention has the following configuration. That is, the present invention is a substrate processing apparatus including: a first substrate holder configured to hold a substrate in a horizontal attitude; a plurality of nozzles configured to dispense a processing solution; a plurality of pipes connected to the nozzles; a nozzle holder configured to hold any one nozzle of the nozzles; an arm coupled to the nozzle holder; and an arm drive section configured to move the arm to move the nozzle held by the nozzle holder, in which each of the nozzles includes: a dispensing port configured to dispense a processing solution; and a connection portion connected to the pipes, each of the pipes includes a downstream end portion connected to the connection portion, each of the pipes has flexibility, the nozzle held by the nozzle holder is defined as a selection nozzle, the arm drive section moves the dispensing port of the selection nozzle to a first processing position for dispensing a processing solution to a substrate held by the first substrate holder, the selection nozzle is rotatable about a rotation axis with respect to the arm, and the rotation axis passes through the dispensing port of the selection nozzle.

The substrate processing apparatus includes a first substrate holder. The first substrate holder holds the substrate in a horizontal attitude. The substrate processing apparatus includes the plurality of nozzles and the plurality of pipes. Each of the plurality of nozzles dispenses the processing solution. The plurality of pipes is connected to the nozzles, respectively. The substrate processing apparatus includes the nozzle holder, the arm, and the arm drive section. The nozzle holder holds any one of the nozzles. The arm is coupled to the nozzle holder. The arm drive section moves the arm. The arm drive section moves the nozzle held by the nozzle holder. Each of the nozzles includes a dispensing port and a connection portion. The dispensing port dispenses the processing solution. Each connection portion is connected to each of the pipes. Each of the pipes includes the downstream end portion. The downstream end portion is connected to the connection portion. Each of the pipes has flexibility. Therefore, it is easy for the downstream end portion to move integrally with the nozzle connected to the downstream end portion.

The nozzle held by the nozzle holder is defined as a selection nozzle. The arm drive section moves the dispensing port of the selection nozzle to the first processing position. The first processing position is for dispensing the processing solution to the substrate held by the first substrate holder. Therefore, it is easy for the selection nozzle to dispense the processing solution to the substrate held by the first substrate holder.

The selection nozzle is rotatable about the rotation axis with respect to the arm. Therefore, the connection portion of the selection nozzle is rotatable about the rotation axis with respect to the arm. The downstream end portion of the pipe connected to the selection nozzle is rotatable about the rotation axis with respect to the arm. Accordingly, it is easy to adjust an orientation of the connection portion of the selection nozzle. It is easy to adjust an orientation of the downstream end portion of the pipe connected to the selection nozzle. Therefore, it is easy to simplify the path of the pipe connected to the selection nozzle.

The rotation axis passes through the dispensing port of the selection nozzle. Therefore, even when the selection nozzle rotates about the rotation axis with respect to the arm, the position of the dispensing port of the selection nozzle does not change. Accordingly, the rotation of the selection nozzle about the rotation axis with respect to the arm does not make it difficult to adjust the position of the dispensing port of the selection nozzle. Therefore, even if the selection nozzle is rotatable about the rotation axis with respect to the arm, it is easy to adjust the position of the dispensing port of the selection nozzle.

In summary, the present substrate processing apparatus simplifies the path of the pipe. More specifically, the present substrate processing apparatus facilitates adjustment of the position of the dispensing port of the nozzle and simplifies the path of the pipe.

In the substrate processing apparatus, preferably, rotation of the selection nozzle about the rotation axis with respect to the arm is independent of movement of the arm by the arm drive section. Therefore, even if the arm does not move, an orientation of the connection portion of the selection nozzle can be changed. In other words, even in a state where the arm is stationary, the orientation of the connection portion of the selection nozzle can be changed.

In the present substrate processing apparatus, the rotation axis preferably extends in a vertical direction. Therefore, it is easier to simplify the path of the pipe connected to the selection nozzle.

In the present substrate processing apparatus, it is preferable that the first processing position is disposed above a substrate held by the first substrate holder, and the dispensing port dispenses a processing solution downward. Therefore, it is easy for the selection nozzle to dispense the processing solution to the substrate held by the first substrate holder.

In the substrate processing apparatus, the connection portion of the selection nozzle preferably extends in a radial direction of the rotation axis. Therefore, it is easier to adjust the orientation of the connection portion of the selection nozzle. Accordingly, it is easier to adjust an orientation of the downstream end portion of the pipe connected to the selection nozzle. Therefore, it is easier to simplify the path of the pipe connected to the selection nozzle.

In the substrate processing apparatus, the downstream end portion of the pipe connected to the selection nozzle preferably extends in a radial direction of the rotation axis. Accordingly, it is easier to adjust an orientation of the downstream end portion of the pipe connected to the selection nozzle. Therefore, it is easier to simplify the path of the pipe connected to the selection nozzle.

In the substrate processing apparatus, the nozzle holder is preferably rotatable about the rotation axis with respect to the arm. Therefore, it is easy for the selection nozzle to rotate about the rotation axis with respect to the arm.

It is preferable that the substrate processing apparatus further includes a nozzle rotation drive section configured to rotate the selection nozzle about the rotation axis with respect to the arm. The substrate processing apparatus includes the nozzle rotation drive section. The nozzle rotation drive section rotates the selection nozzle about the rotation axis with respect to the arm. Therefore, it is easy for the selection nozzle to rotate about the rotation axis with respect to the arm. Moreover, it is easy to adjust a position of the selection nozzle about the rotation axis with respect to the arm. Accordingly, it is easy to adjust a relative position of the connection portion of the selection nozzle with respect to the arm. Therefore, it is easy to adjust the orientation of the connection portion of the selection nozzle.

In the substrate processing apparatus, the nozzle rotation drive section preferably rotates the nozzle holder about the rotation axis with respect to the arm. Therefore, it is easy for the nozzle rotation drive section to rotate the selection nozzle about the rotation axis with respect to the arm.

It is preferable that the substrate processing apparatus further includes a controller configured to control the nozzle rotation drive section. Therefore, it is easy for the nozzle rotation drive section to rotate the selection nozzle about the rotation axis with respect to the arm.

In the substrate processing apparatus, preferably, the controller has relationship information, the relationship information defines a relationship between a position of the dispensing port of the selection nozzle and a position of the selection nozzle about the rotation axis with respect to the arm, and the controller controls the nozzle rotation drive section on the basis of the relationship information. Therefore, it is easy for the controller to control the nozzle rotation drive section.

In the substrate processing apparatus, it is preferable that one of the nozzles is defined as a first nozzle, the other one of the nozzles is defined as a second nozzle, and an orientation of the connection portion of the first nozzle when the dispensing port of the first nozzle is located at the first processing position is different from an orientation of the connection portion of the second nozzle when the dispensing port of the second nozzle is located at the first processing position. Therefore, when the dispensing port of the first nozzle is located at the first processing position, it is easy to simplify the path of the pipe connected to the first nozzle. When the dispensing port of the second nozzle is located at the first processing position, it is easy to simplify the path of the pipe connected to the second nozzle.

In the substrate processing apparatus, preferably, one of the nozzles is defined as a first nozzle, the other one of the nozzles is defined as a second nozzle, the pipe connected to the first nozzle is defined as a first pipe, the pipe connected to the second nozzle is defined as a second pipe, and an orientation of the downstream end portion of the first pipe when the dispensing port of the first nozzle is located at the first processing position is different from an orientation of the downstream end portion of the second pipe when the dispensing port of the second nozzle is located at the first processing position. Therefore, when the dispensing port of the first nozzle is located at the first processing position, it is easy to simplify the path of the pipe connected to the first nozzle. When the dispensing port of the second nozzle is located at the first processing position, it is easy to simplify the path of the pipe connected to the second nozzle.

In the substrate processing apparatus, the selection nozzle preferably rotates about the rotation axis with respect to the arm so that the number of bent portions included in the pipe connected to the selection nozzle is one. Therefore, it is easy to simplify the path of the pipe connected to the selection nozzle.

In the substrate processing apparatus, it is preferable that while the arm drive section moves the selection nozzle, the selection nozzle rotates about the rotation axis with respect to the arm. Therefore, when the arm drive section moves the selection nozzle, it is easy to keep the path of the pipe connected to the selection nozzle simple.

In the substrate processing apparatus, each of the pipes preferably includes: an upstream end portion fixed at a predetermined position; an upstream portion linearly extending from the upstream end portion; a first bent portion bent from the upstream portion; and a downstream portion linearly extending from the first bent portion to the downstream end portion. Each of the pipes includes the upstream end portion in addition to the downstream end portion. The upstream end portion is fixed at the predetermined position. Therefore, the substrate processing apparatus does not include a mechanism for moving the upstream end portion. Therefore, it is easy to downsize the substrate processing apparatus.

Moreover, each of the pipes includes the upstream portion, the first bent portion, and the downstream portion. The upstream portion extends from the upstream end portion. The upstream portion extends linearly. The first bent portion is bent from the upstream portion. The downstream portion extends from the first bent portion to the downstream end portion. The downstream portion extends linearly. Therefore, each of the pipes is bent only at the first bent portion. In other words, each of the pipes is not bent except for the first bent portion. Each of the pipes extends linearly at a portion other than the first bent portion. Accordingly, it is easy to limit the number of bent portions included in the pipe to one.

In the substrate processing apparatus, the selection nozzle preferably rotates about the rotation axis with respect to the arm so that the connection portion of the selection nozzle is directed to the first bent portion of the pipe connected to the selection nozzle. Therefore, it is easy for the downstream portion of the pipe connected to the selection nozzle to extend from the downstream end portion toward the first bent portion. Accordingly, it is easy for the downstream portion of the pipe connected to the selection nozzle to linearly extend from the downstream end portion to the first bent portion. In other words, it is easy for the entire downstream portion of the pipe connected to the selection nozzle to extend linearly.

In the substrate processing apparatus, the selection nozzle preferably rotates about the rotation axis with respect to the arm such that the downstream end portion of the pipe connected to the selection nozzle is directed to the first bent portion of the pipe connected to the selection nozzle. Therefore, it is easy for the downstream portion of the pipe connected to the selection nozzle to extend from the downstream end portion toward the first bent portion. Accordingly, it is easy for the downstream portion of the pipe connected to the selection nozzle to linearly extend from the downstream end portion to the first bent portion.

In the substrate processing apparatus, it is preferable that each of a plurality of the upstream end portions of the plurality of pipes extends in a first direction in plan view, a plurality of the upstream portions of the plurality of pipes is arranged in a second direction, the first direction is horizontal, the second direction is horizontal and orthogonal to the first direction, the first bent portion is bent vertically, a vertical virtual plane including the upstream end portion of the pipe connected to the selection nozzle is defined as a selection virtual plane, the first processing position is shifted from the selection virtual plane in the second direction in plan view, and the selection nozzle rotates about the rotation axis with respect to the arm so that the first bent portion of the pipe connected to the selection nozzle is suppressed from being shifted from the selection virtual plane in the second direction in plan view. Each upstream end portion extends in the first direction in plan view. The first direction is horizontal. The plurality of upstream portions is arranged in the second direction. The second direction is horizontal. The second direction is orthogonal to the first direction. The first bent portion is bent vertically. The selection virtual plane is a virtual plane. The selection virtual plane includes the upstream end portion of the pipe connected to the selection nozzle. The selection virtual plane is vertical. The first processing position is shifted in the second direction from the selection virtual plane in plan view. In other words, the first processing position is not located on the selection virtual plane in plan view. Therefore, the first processing position is shifted in the second direction from the upstream end portion of the pipe connected to the selection nozzle. Accordingly, when the dispensing port of the selection nozzle is located at the first processing position, the downstream end portion of the pipe connected to the selection nozzle is shifted in the second direction from the upstream end portion of the pipe connected to the selection nozzle.

Here, the selection nozzle rotates about the rotation axis with respect to the arm so as to suppress the first bent portion of the pipe connected to the selection nozzle from being shifted in the second direction from the selection virtual plane in plan view. Therefore, it is easy to prevent interference between the plurality of pipes. For example, it is easy to prevent the first bent portion of the pipe connected to the selection nozzle from coming into contact with the pipe connected to the nozzle other than the selection nozzle. For example, it is easy to prevent contact between the pipes adjacent in the second direction.

In the substrate processing apparatus, the selection nozzle preferably rotates about the rotation axis with respect to the arm so that the first bent portion of the pipe connected to the selection nozzle moves on the selection virtual plane in plan view when the arm drive section moves the selection nozzle. Therefore, it is easy to prevent interference between the plurality of pipes.

It is preferable that the substrate processing apparatus further includes a nozzle standby section configured to cause the plurality of nozzles to stand by, in which the arm drive section moves the selection nozzle to the nozzle standby section, and a relative position of the connection portion of the selection nozzle with respect to the arm when the selection nozzle stands by in the nozzle standby section is different from a relative position of the connection portion of the selection nozzle with respect to the arm when the dispensing port of the selection nozzle is located at the first processing position. The substrate processing apparatus includes the nozzle standby section. The nozzle stands by in the nozzle standby section. The arm drive section moves the selection nozzle to the nozzle standby section. The relative position of the connection portion of the selection nozzle with respect to the arm when the selection nozzle stands by in the nozzle standby section is different from the relative position of the connection portion of the selection nozzle with respect to the arm when the dispensing port of the selection nozzle is located at the first processing position. Therefore, when the selection nozzle stands by in the nozzle standby section, it is easy to simplify the path of the pipe connected to the selection nozzle. When the dispensing port of the selection nozzle is located at the first processing position, it is easy to simplify the path of the pipe connected to the selection nozzle.

In the substrate processing apparatus, it is preferable that one of the nozzles is defined as a first nozzle, a position of the dispensing port of the first nozzle on standby in the nozzle standby section is defined as a first standby position, and a virtual straight line connecting the first standby position and the first processing position is defined as a first virtual line, and the arm drive section moves the dispensing port of the first nozzle along the first virtual line in plan view. Therefore, the dispensing port of the first nozzle linearly moves between the first standby position and the first processing position in plan view. Accordingly, it is easy to simplify the path along which the first nozzle moves. Therefore, when the first nozzle moves, it is easy to keep the path of the pipe connected to the first nozzle simple.

It is preferable that the present substrate processing apparatus further includes a second substrate holder configured to hold a substrate in a horizontal attitude, in which the arm drive section moves the dispensing port of the selection nozzle to a second processing position for dispensing a processing solution to the substrate held by the second substrate holder. The substrate processing apparatus includes the second substrate holder. The second substrate holder holds the substrate in a horizontal attitude. The arm drive section moves the dispensing port of the selection nozzle to the second processing position. The second processing position is for dispensing the processing solution to the substrate held by the second substrate holder. Therefore, the nozzle is used not only for processing the substrate on the first substrate holder but also for processing the substrate on the second substrate holder. Accordingly, it is easy to reduce the number of nozzles included in the substrate processing apparatus. Similarly, the nozzle holder, the arm, and the arm drive section are used not only for processing the substrate on the first substrate holder but also for processing the substrate on the second substrate holder. Accordingly, it is easy to reduce the number of nozzle holders, the number of arms, and the number of arm drive sections. Therefore, it is easy to downsize the substrate processing apparatus.

In the present substrate processing apparatus, it is preferable that one of the nozzles is defined as a first nozzle, and an orientation of the connection portion of the first nozzle when the dispensing port of the first nozzle is located at the second processing position is different from an orientation of the connection portion of the first nozzle when the dispensing port of the first nozzle is located at the first processing position. Therefore, when the dispensing port of the first nozzle is located at the first processing position, it is easy to simplify the path of the pipe connected to the first nozzle. When the dispensing port of the first nozzle is located at the second processing position, it is easy to simplify the path of the pipe connected to the first nozzle.

### BRIEF DESCRIPTION OF THE DRAWINGS

For the purpose of illustrating the invention, there are shown in the drawings several forms which are presently preferred, it being understood, however, that the invention is not limited to the precise arrangement and instrumentalities shown.
FIG. 1 is a plan view of a substrate processing apparatus according to an embodiment;
FIG. 2 is a side view of the substrate processing apparatus;
FIG. 3 is a control block diagram of the substrate processing apparatus;
FIG. 4 is a plan view of a coating processing unit;
FIG. 5 is a side view of the coating processing unit;
FIG. 6 is a plan view of a part of the coating processing unit;
FIG. 7 is a side view of the coating processing unit;
FIG. 8 is a bottom view of a selection nozzle, a nozzle holder, and an arm;
FIG. 9 is a diagram schematically illustrating an arm drive section;
FIG. 10 is a plan view of the coating processing unit;
FIG. 11 is a plan view of the coating processing unit;
FIG. 12 is a bottom view of a nozzle and the arm;
FIG. 13 is a plan view of the coating processing unit;
FIG. 14 is a side view of a pipe;
FIGS. 15A, 15B, and 15C are perspective views for describing a relationship between the nozzle and the pipe;
FIGS. 16A, 16B, and 16C are plan views for describing a relationship between the nozzle and the pipe;
FIG. 17 is a plan view of the coating processing unit;
FIG. 18 is a plan view of the coating processing unit;
FIG. 19 is a plan view of the coating processing unit;
FIG. 20 is a plan view of the coating processing unit;
FIG. 21 is a perspective view of a nozzle and an engagement portion of a modified embodiment;
FIG. 22 is a perspective view of the nozzle and the engagement portion of the modified embodiment;
FIG. 23 is a cross-sectional view of the nozzle and the engagement portion of the modified embodiment;
FIG. 24 is a perspective view of a coating processing unit of the modified embodiment;
FIG. 25 is a plan view of the coating processing unit of the modified embodiment; and
FIG. 26 is a plan view of the coating processing unit of the modified embodiment.

### DETAILED DESCRIPTION

Hereinafter, a substrate processing apparatus of the present invention will be described with reference to the drawings.

### <1. Outline of substrate processing apparatus>

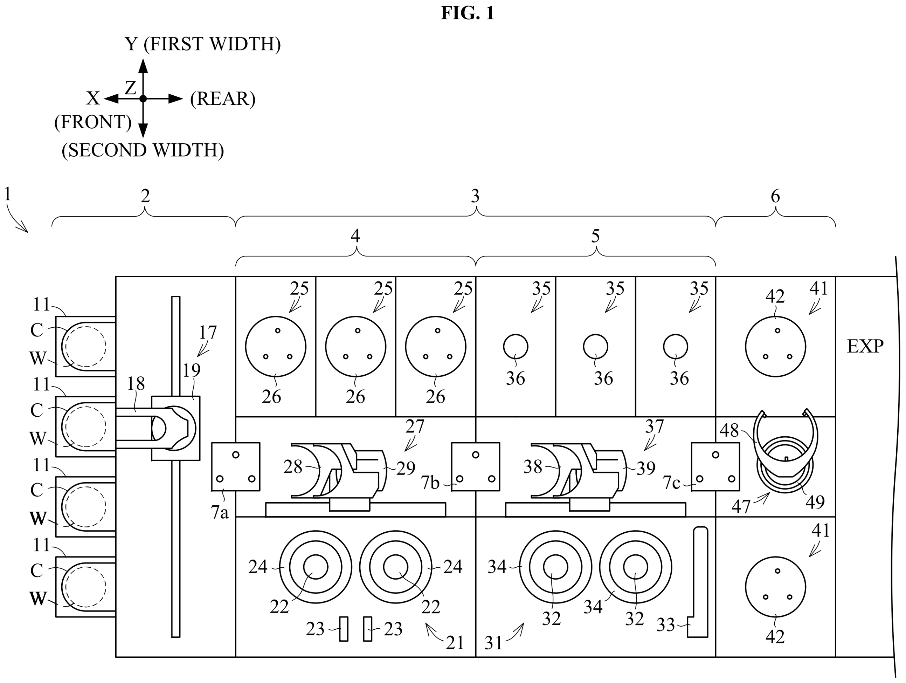

FIG. 1 is a plan view of a substrate processing apparatus 1 according to an embodiment. The substrate processing apparatus 1 performs processing on a substrate W.

The substrate W is, for example, any of a semiconductor wafer, a liquid crystal display substrate, an organic electroluminescence (OEL) substrate, a flat panel display (FPD) substrate, an optical display substrate, a magnetic disk substrate, an optical disk substrate, a magneto-optical disk substrate, a photomask substrate, and a solar cell substrate.

The substrate W has a thin flat plate shape. The substrate W has a substantially circular shape in plan view.

The substrate processing apparatus 1 includes an indexer block 2 and a processing block 3. The processing block 3 is connected to the indexer block 2. For example, the indexer block 2 and the processing block 3 are arranged in a horizontal direction.

The substrate processing apparatus 1 includes an interface block 6. The interface block 6 is connected to the processing block 3.

The substrate processing apparatus 1 is connected to an exposure machine EXP. The interface block 6 is connected to the exposure machine EXP. The exposure machine EXP is an external element of the substrate processing apparatus 1.

For convenience, the horizontal direction in which the indexer block 2 and the processing block 3 are arranged is referred to as a "front-rear direction X". The front-rear direction X includes a "front direction" and a "rear direction". The front direction is a direction from the processing block 3 toward the indexer block 2. The rear direction is a direction opposite to the front direction. The horizontal direction orthogonal to the front-rear direction X is referred to as a "width direction Y". The "width direction Y" includes a "first width direction" and a "second width direction". The second width direction is a direction opposite to the first width direction. A direction perpendicular to the horizontal direction is referred to as a "vertical direction Z". The vertical direction Z includes an "upward direction" and a "downward direction". In each drawing, the front direction is indicated by "FRONT". The rear direction is indicated by "REAR". The first width direction is indicated by "FIRST WIDTH". The second width direction is indicated by "SECOND WIDTH". The upward direction is indicated by "UP". The downward direction is indicated by "DOWN".

The indexer block 2 will be described. The indexer block 2 includes a plurality of carrier placement portions 11. Each of the carrier placement portions 11 supports one carrier C. The carrier C accommodates a plurality of the substrates W. In the carrier C, each substrate W is supported in a horizontal attitude. The carrier C is, for example, a front opening unified pod (FOUP), a standard mechanical interface (SMIF), or an open cassette (OC).

The indexer block 2 includes a conveyance mechanism 17. The conveyance mechanism 17 conveys the substrate W. The conveyance mechanism 17 is, for example, a conveyance robot.

The conveyance mechanism 17 includes a hand 18. The hand 18 supports the substrate W in a horizontal attitude.

The conveyance mechanism 17 includes a hand drive section 19. The hand drive section 19 is coupled to the hand 18. The hand drive section 19 moves the hand 18. The hand drive section 19 moves the hand 18 in the horizontal direction and the vertical direction Z, for example. The hand drive section 19 rotates the hand 18 in a horizontal plane, for example.

The processing block 3 will be described. The processing block 3 includes a coating block 4. The coating block 4 is connected to the indexer block 2.

The coating block 4 includes a coating processing unit 21. The coating processing unit 21 performs coating processing on the substrate W. The coating processing is for forming a coating film on the substrate W. The coating film includes, for example, at least one of a resist film, an antireflection film, an insulating film, and a base film. The coating processing unit 21 is rephrased as a coating processing chamber 21.

The coating processing unit 21 includes a substrate holder 22 and a nozzle 23. The substrate holder 22 holds the substrate W in a horizontal attitude. The substrate holder 22 is, for example, a substrate chuck. The nozzle 23 dispenses a processing solution. The processing solution is, for example, a coating film material. The coating film material includes, for example, a resist film material.

The coating processing unit 21 includes a cup 24. The cup 24 is disposed around the substrate holder 22. The cup 24 collects the processing solution scattered from the substrate W held by the substrate holder 22.

The coating block 4 includes a plurality of heat treatment units 25. Each of the heat treatment units 25 performs heat treatment on the substrate W. The heat treatment includes at least one of a treatment of heating the substrate W and a treatment of cooling the substrate W. The heat treatment unit 25 is rephrased as a heat treatment chamber 25.

The heat treatment unit 25 includes a heat treatment plate 26. The heat treatment plate 26 supports the substrate W in a horizontal attitude.

The heat treatment unit 25 includes a temperature control section (not illustrated). The temperature control section includes, for example, at least one of a heater and a cooler. The temperature control section adjusts the temperature of the substrate W on the heat treatment plate 26.

The coating block 4 includes a conveyance mechanism 27. The conveyance mechanism 27 conveys the substrate W. The conveyance mechanism 27 is, for example, a conveyance robot.

The conveyance mechanism 27 includes a hand 28. The hand 28 supports the substrate W in a horizontal attitude.

The conveyance mechanism 27 includes a hand drive section 29. The hand drive section 29 is coupled to the hand 28. The hand drive section 29 moves the hand 28. The hand drive section 29 moves the hand 28 in the horizontal direction and the vertical direction Z, for example. The hand drive section 29 rotates the hand 28 in a horizontal plane, for example.

The processing block 3 includes a development block 5. The development block 5 is connected to the coating block 4. The development block 5 is connected to the interface block 6.

The development block 5 includes a development processing unit 31. The development processing unit 31 performs development processing on the substrate W. For example, the development processing is for developing the substrate W. For example, the development processing is for developing a resist film on the substrate W. The development processing unit 31 is rephrased as a development processing chamber 31.

The development processing unit 31 includes a substrate holder 32 and a nozzle 33. The substrate holder 32 holds the substrate W in a horizontal attitude. The substrate holder 32 is, for example, a substrate chuck. The nozzle 33 dispenses a processing solution onto the substrate W. The processing solution is, for example, a developer.

The development processing unit 31 includes a cup 34. The cup 34 is disposed around the substrate holder 32. The cup 34 collects the processing solution scattered from the substrate W held by the substrate holder 32.

The development block 5 includes a plurality of edge exposure units 35. The edge exposure unit 35 exposes a peripheral edge portion of the substrate W. The edge exposure unit 35 is rephrased as an edge exposure chamber 35.

The edge exposure unit 35 includes the substrate holder 36. The substrate holder 36 holds the substrate W in a horizontal attitude.

The edge exposure unit 35 includes a light irradiation section (not illustrated). The light irradiation section irradiates the peripheral edge portion of the substrate W held by the substrate holder 36 with light.

The development block 5 includes a conveyance mechanism 37. The conveyance mechanism 37 conveys the substrate W. The conveyance mechanism 37 is, for example, a conveyance robot.

The conveyance mechanism 37 includes a hand 38. The hand 38 supports the substrate W in a horizontal attitude.

The conveyance mechanism 37 includes a hand drive section 39. The hand drive section 39 is coupled to the hand 38. The hand drive section 39 moves the hand 38. The hand drive section 39 moves the hand 38 in the horizontal direction and the vertical direction Z, for example. The hand drive section 39 rotates the hand 38 in a horizontal plane, for example.

The interface block 6 will be described. The interface block 6 includes a plurality of heat treatment units 41. Each of the heat treatment units 41 performs heat treatment on the substrate W. The heat treatment includes, for example, post exposure heat treatment (Post Exposure Bake). The heat treatment unit 41 is rephrased as a heat treatment chamber 41.

The heat treatment unit 41 includes a heat treatment plate 42. The heat treatment plate 42 supports the substrate W in a horizontal attitude.

The heat treatment unit 41 includes a temperature control section (not illustrated). The temperature control section includes, for example, at least one of a heater and a cooler. The temperature control section adjusts the temperature of the substrate W on the heat treatment plate 42.

The interface block 6 includes a conveyance mechanism 47. The conveyance mechanism 47 conveys the substrate W. The conveyance mechanism 47 is, for example, a conveyance robot.

The conveyance mechanism 47 includes a hand 48. The hand 48 supports the substrate W in a horizontal attitude.

The conveyance mechanism 47 includes a hand drive section 49. The hand drive section 49 is coupled to the hand 48. The hand drive section 49 moves the hand 48. The hand drive section 49 moves the hand 48 in the horizontal direction and the vertical direction Z, for example. The hand drive section 49 rotates the hand 48 in a horizontal plane, for example.

The substrate processing apparatus 1 includes substrate placement portions 7a, 7b, and 7c. The substrate placement portion 7a is disposed between the indexer block 2 and the coating block 4. The substrate placement portion 7b is disposed between the coating block 4 and the development block 5. The substrate placement portion 7c is disposed between the development block 5 and the interface block 6. Each of the substrate placement portions 7a, 7b, and 7c supports the substrate W.

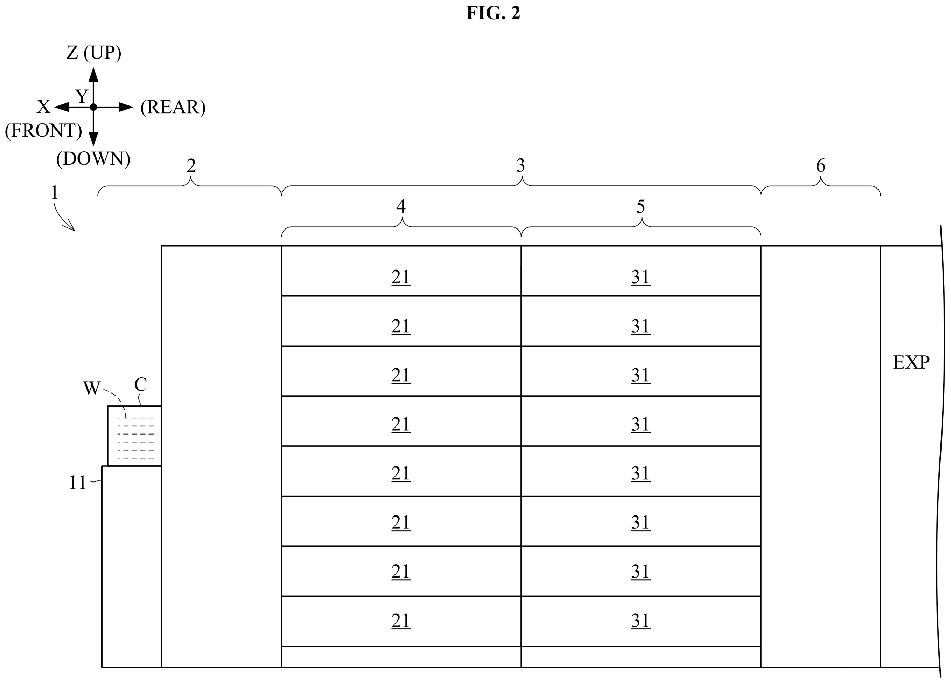

FIG. 2 is a side view of the substrate processing apparatus 1. The coating block 4 includes a plurality of the coating processing units 21 described above. The plurality of coating processing units 21 is arranged in the vertical direction Z. The number of coating processing units 21 arranged in the vertical direction Z is large. For example, the number of coating processing units 21 arranged in the vertical direction Z is eight.

One coating processing unit 21 is small. The length of one coating processing unit 21 in the vertical direction Z is small. Therefore, the length of the substrate processing apparatus 1 in the vertical direction Z is small.

Similarly, the development block 5 includes a plurality of the development processing units 31 described above. The plurality of development processing units 31 is arranged in the vertical direction Z.

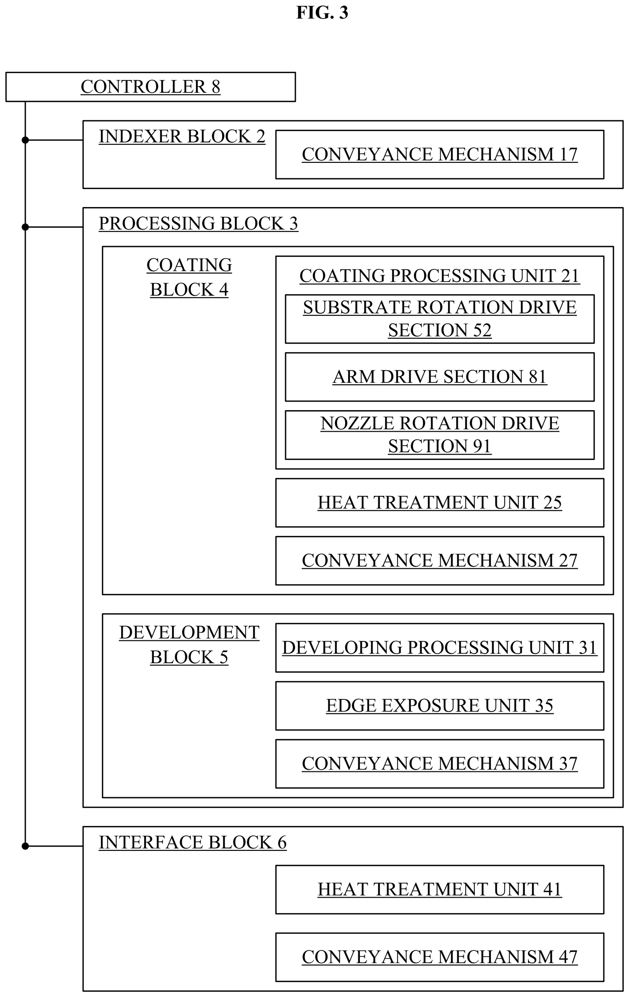

FIG. 3 is a control block diagram of the substrate processing apparatus 1. The substrate processing apparatus 1 includes a controller 8. The controller 8 controls the indexer block 2. The controller 8 controls the conveyance mechanism 17. The controller 8 controls the processing block 3. The controller 8 controls the coating block 4. The controller 8 controls the coating processing unit 21, the heat treatment unit 25, and the conveyance mechanism 27. The controller 8 controls the development block 5. The controller 8 controls the development processing unit 31, the edge exposure unit 35, and the conveyance mechanism 37. The controller 8 controls the interface block 6. The controller 8 controls the heat treatment unit 41 and the conveyance mechanism 47.

The controller 8 is realized by, for example, a central processing unit (CPU), a random access memory (RAM), and a storage medium. The central processing unit executes arithmetic processing. The random access memory functions as a work area for arithmetic processing. The storage medium is, for example, a fixed disk. The controller 8 has various types of information. The various types of information are stored in advance in the storage medium. The information included in the controller 8 includes, for example, substrate conveyance information and processing information. The substrate conveyance information defines a procedure of conveyance of the substrate W. The processing information defines a procedure of processing the substrate W. The processing information is also referred to as a processing recipe.

A simple operation example of the substrate processing apparatus 1 will be described.

Refer to FIG. 1. An operation example of the substrate processing apparatus 1 will be described. The indexer block 2 conveys the substrate W to the processing block 3. Specifically, the conveyance mechanism 17 conveys the substrate W from the carrier C on the carrier placement portion 11 to the substrate placement portion 7a.

The processing block 3 performs processing on the substrate W.

The conveyance mechanism 27 conveys the substrate W from the substrate placement portion 7a to the coating processing unit 21. The hand 28 places the substrate W on the substrate holder 22. The coating processing unit 21 performs coating processing on the substrate W. The nozzle 23 dispenses the processing solution to the substrate W held by the substrate holder 22.

Thereafter, the conveyance mechanism 27 conveys the substrate W from the coating processing unit 21 to the heat treatment unit 25. The heat treatment unit 25 performs heat treatment on the substrate W on the heat treatment plate 26. The conveyance mechanism 27 conveys the substrate W from the heat treatment unit 25 to the substrate placement portion 7b. The conveyance mechanism 37 conveys the substrate W from the substrate placement portion 7b to the edge exposure unit 35. The edge exposure unit 35 exposes the peripheral edge portion of the substrate W held by the substrate holder 36. The conveyance mechanism 37 conveys the substrate W from the edge exposure unit 35 to the substrate placement portion 7c.

The interface block 6 conveys the substrate W between the processing block 3 and the exposure machine EXP. Specifically, the conveyance mechanism 47 conveys the substrate W from the substrate placement portion 7c to the exposure machine EXP. The exposure machine EXP performs exposure processing on the substrate W. The conveyance mechanism 47 conveys the substrate W from the exposure machine EXP to the heat treatment unit 41. The heat treatment unit 41 performs post exposure heat treatment on the substrate W on the heat treatment plate 42. The conveyance mechanism 47 conveys the substrate W from the heat treatment unit 41 to the substrate placement portion 7c.

The processing block 3 performs processing on the substrate W. Specifically, the conveyance mechanism 37 conveys the substrate W from the substrate placement portion 7c to the development processing unit 31. The development processing unit 31 performs development processing on the substrate W. The nozzle 33 dispenses the processing solution to the substrate W held by the substrate holder 32. The conveyance mechanism 37 conveys the substrate W from the development processing unit 31 to the substrate placement portion 7b. The conveyance mechanism 27 conveys the substrate W from the substrate placement portion 7b to the substrate placement portion 7a.

The indexer block 2 collects the substrate W from the processing block 3. Specifically, the conveyance mechanism 17 conveys the substrate W from the substrate placement portion 7a to the carrier C on the carrier placement portion 11.

### <2. Detailed configuration of coating processing unit 21>

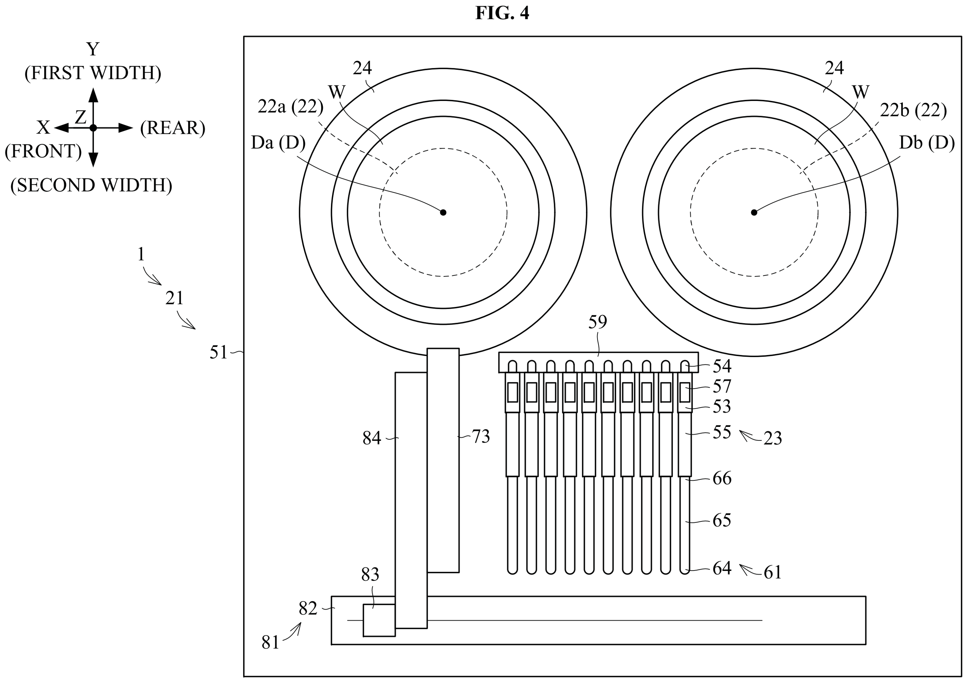

FIG. 4 is a plan view of the coating processing unit 21. Each coating processing unit 21 includes a housing 51. The housing 51 has a box shape.

The housing 51 accommodates a plurality of the substrate holders 22 and a plurality of the cups 24. For example, the housing 51 accommodates two substrate holders 22 and two cups 24.

The plurality of substrate holders 22 is arranged in the front-rear direction X. The plurality of cups 24 is arranged in the front-rear direction X. Each of the cups 24 has a substantially cylindrical shape. The substrate holder 22 is disposed inside the cup 24.

In a case where the substrate holders 22 are distinguished, one substrate holder 22 is referred to as a "substrate holder 22a", and the other substrate holder 22 is referred to as a "substrate holder 22b". The substrate holder 22a and the substrate holder 22b are arranged in the front-rear direction X. The substrate holder 22b is disposed behind the substrate holder 22a. The conveyance mechanism 27 alternately conveys the substrate W to the substrate holder 22a and the substrate holder 22b.

The housing 51 accommodates a plurality of the nozzles 23. For example, the housing 51 accommodates ten nozzles 23.

The composition of the processing solution dispensed from one nozzle 23 is different from the composition of the processing solution dispensed from the other at least one nozzle 23.

Each nozzle 23 dispenses the processing solution to the substrate W held by the substrate holder 22a and the substrate W held by the substrate holder 22b.

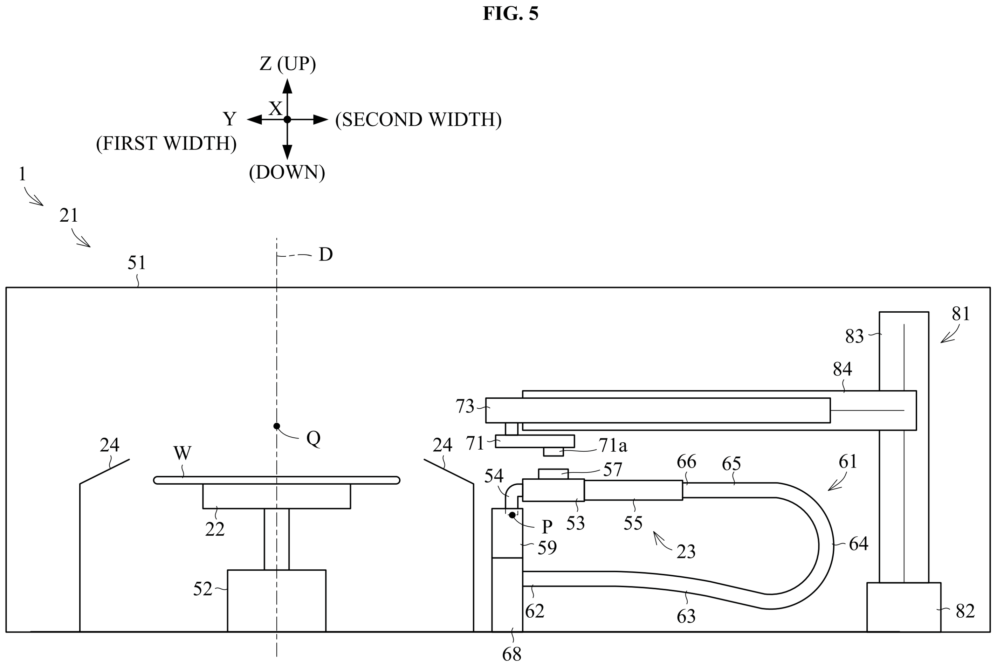

FIG. 5 is a side view of the coating processing unit 21. Each substrate holder 22 holds the substrate W in a horizontal attitude. Each substrate holder 22 holds one substrate W at a time. For example, each substrate holder 22 holds a lower surface of the substrate W. For example, each substrate holder 22 adsorbs and holds the substrate W.

The coating processing unit 21 includes a substrate rotation drive section 52. The substrate rotation drive section 52 is coupled to the substrate holder 22. The substrate rotation drive section 52 rotates the substrate holder 22. The substrate rotation drive section 52 includes, for example, an electric motor.

The substrate rotation drive section 52 rotates the substrate holder 22 about the substrate rotation axis D. The substrate rotation drive section 52 rotates the substrate W held by the substrate holder 22 about the substrate rotation axis D. The substrate rotation axis D extends, for example, in the vertical direction Z.

The structure of the nozzle 23 will be described. Each nozzle 23 includes a nozzle body 53. The nozzle body 53 includes a dispensing port 54. The dispensing port 54 dispenses the processing solution.

The dispensing port 54 is opened downward. The dispensing port 54 dispenses the processing solution downward.

Each nozzle 23 includes a connection portion 55. The connection portion 55 is coupled to the nozzle body 53. The connection portion 55 is fixed to the nozzle body 53. The connection portion 55 is, for example, a short straight pipe. The connection portion 55 does not have flexibility.

The connection portion 55 extends in the horizontal direction. The connection portion 55 communicates with the dispensing port 54.

The coating processing unit 21 includes a plurality of engagement portions 57. Each of the engagement portion 57 is coupled to the nozzle 23. For example, the engagement portions 57 is coupled to the nozzle body 53. The engagement portion 57 is disposed above the nozzle body 53.

The engagement portion 57 is fixed to the nozzle 23. The engagement portion 57 is not rotatable with respect to the nozzle 23. For example, the engagement portion 57 is fixed to the nozzle body 53.

Although not illustrated, the engagement portion 57 has, for example, a box shape opened upward. Specifically, the engagement portion 57 includes a side wall. The side wall extends upward from the nozzle body 53. The side wall forms a recess. The recess is surrounded by the side wall.

The coating processing unit 21 includes a nozzle standby section 59. The nozzle standby section 59 causes the plurality of nozzles 23 to stand by. The nozzle standby section 59 supports the plurality of nozzles 23.

The nozzle standby section 59 is disposed at a predetermined position. The nozzle standby section 59 is disposed outside the cup 24.

The nozzle standby section 59 is fixed to the housing 51. The nozzle standby section 59 is not movable with respect to the housing 51. The nozzle standby section 59 is not rotatable with respect to the housing 51.

The coating processing unit 21 includes a plurality of pipes 61. Each of the pipes 61 is connected to the nozzle 23. More specifically, the pipe 61 is connected to the connection portion 55. The pipe 61 supplies the processing solution to the nozzle 23.

The pipe 61 has flexibility. The pipe 61 is flexible.

The configuration of the pipe 61 will be described.

The pipe 61 includes an upstream end portion 62, an upstream portion 63, a first bent portion 64, a downstream portion 65, and a downstream end portion 66. The processing solution flows through the upstream end portion 62, the upstream portion 63, the first bent portion 64, the downstream portion 65, and the downstream end portion 66 in this order.

The upstream end portion 62 is disposed at a predetermined position. The upstream end portion 62 is disposed outside the cup 24. The upstream end portion 62 is disposed, for example, below the nozzle standby section 59. The upstream end portion 62 is disposed, for example, below the nozzle 23 standing by in the nozzle standby section 59.

The upstream end portion 62 is fixed. The upstream end portion 62 is fixed to the housing 51. The upstream end portion 62 is immovable relative to the housing 51. The upstream end portion 62 is non-rotatable with respect to the housing 51.

The upstream end portion 62 extends in the horizontal direction. The upstream end portion 62 extends in the width direction Y.

The upstream portion 63 extends from the upstream end portion 62. The upstream portion 63 extends to the first bent portion 64. The upstream portion 63 extends linearly. The upstream portion 63 extends substantially horizontally. The upstream portion 63 extends in the width direction Y. The upstream portion 63 extends in the second width direction from the upstream end portion 62.

The first bent portion 64 is bent from the upstream portion 63. The first bent portion 64 is bent to the downstream portion 65. The first bent portion 64 is bent vertically. The first bent portion 64 is bent upward from the upstream portion 63. The first bent portion 64 has a U-shape in side view. The first bent portion 64 changes an orientation of the pipe 61 by about 180 degrees. The pipe 61 is folded back at the first bent portion 64.

The downstream portion 65 extends from the first bent portion 64. The downstream portion 65 extends to the downstream end portion 66. The downstream portion 65 extends linearly. The downstream portion 65 extends substantially horizontally. The downstream portion 65 is disposed at a position higher than the upstream portion 63.

The downstream end portion 66 extends from the downstream portion 65. The downstream end portion 66 extends to the connection portion 55. The downstream end portion 66 is connected to the connection portion 55. The downstream end portion 66 extends linearly. The downstream end portion 66 is substantially horizontal. The downstream end portion 66 is disposed at a position higher than the upstream end portion 62.

A bent portion included in the pipe 61 is only the first bent portion 64. The number of bent portions included in the pipe 61 is one.

The coating processing unit 21 includes a fixing member 68. The fixing member 68 is fixed to the housing 51.

The pipe 61 is connected to the fixing member 68. The upstream end portion 62 is connected to the fixing member 68. For example, the upstream end portion 62 extends in the second width direction from the fixing member 68.

The fixing member 68 is disposed outside the cup 24. For example, the fixing member 68 is disposed below the nozzle standby section 59.

The fixing member 68 includes, for example, at least one of a pipe joint, a pipe fastener, and a pipe clamp. The fixing member 68 may include, for example, temperature control equipment that adjusts a temperature of the processing solution.

Although not illustrated, the substrate processing apparatus 1 includes a processing solution supply source. The processing solution supply source is connected to the fixing member 68. The processing solution supply source communicates with the pipe 61 via the fixing member 68. The processing solution supply source supplies the processing solution to the pipe 61.

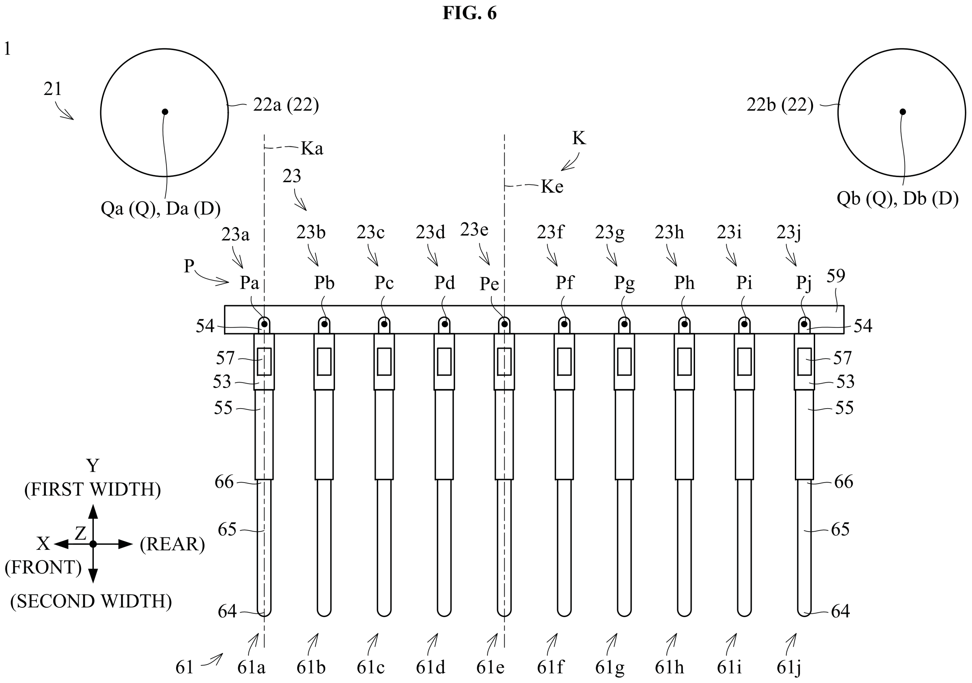

FIG. 6 is a plan view of a part of the coating processing unit 21. For convenience, illustration of the cup 24 and the like is omitted in FIG. 6. To clearly show each nozzle 23, the spacing between the plurality of nozzles 23 in FIG. 6 is wider than the spacing between the plurality of nozzles 23 in other drawings.

In a case where the nozzles 23 are distinguished, the nozzles 23 are referred to as a nozzle 23a, a nozzle 23b,..., and a nozzle 23j. In FIG. 6, the nozzles 23a to 23j stand by in the nozzle standby section 59.

When the plurality of nozzles 23 is on standby in the nozzle standby section 59, the plurality of nozzles 23 is arranged in the horizontal direction. For example, the plurality of nozzles 23 is arranged in the front-rear direction X in the nozzle standby section 59.

The plurality of nozzles 23 is not in contact with each other. The plurality of nozzles 23 is separated from each other. For example, the nozzle 23a is not in contact with any of the nozzles 23b to 23j.

The position of the dispensing port 54 of the nozzle 23a on standby in the nozzle standby section 59 is defined as a standby position Pa. The positions of the dispensing ports 54 of the nozzles 23b to 23j on standby in the nozzle standby section 59 are defined as standby positions Pb to Pj, respectively. In FIG. 6, the dispensing port 54 of the nozzle 23a is located at the standby position Pa. In FIG. 6, the dispensing ports 54 of the nozzles 23b to 23j are located at the standby positions Pb to Pj, respectively.

For example, the standby positions Pa to Pj are arranged in the front-rear direction X.

In a case where the standby positions Pa to Pj are not distinguished, it is referred to as a standby position P. The standby position P is disposed outside the cup 24. The standby position P does not overlap with the substrate holder 22 in plan view. The standby position P overlaps the nozzle standby section 59 in plan view.

The number of the engagement portions 57 is equal to the number of the nozzles 23. One engagement portion 57 is coupled to one nozzle 23. One nozzle 23 is coupled to one engagement portion 57.

The plurality of engagement portions 57 is not in contact with each other. The plurality of engagement portions 57 is separated from each other. For example, the engagement portion 57 coupled to the nozzle 23a is not in contact with any of the engagement portions 57 coupled to the nozzles 23b to 23j.

The engagement portion 57 does not support the pipe 61. The engagement portion 57 is not in contact with the pipe 61.

The number of pipes 61 is equal to the number of nozzles 23. One pipe 61 is connected to one nozzle 23. One nozzle 23 is connected to one pipe 61.

In a case where the pipes 61 are distinguished, the pipes 61 are referred to as a pipe 61a, a pipe 61b,..., and a pipe 61j. The pipe 61a is connected to the nozzle 23a. The pipe 61a is not connected to the nozzles 23b to 23j. The nozzle 23a is not connected to the pipes 61b to 61j. Similarly, the pipes 61b to 61j are connected to the nozzles 23b to 23j, respectively.

Specifically, the downstream end portion 66 of the pipe 61a is connected to the connection portion 55 of the nozzle 23a. The downstream end portions 66 of the pipes 61b to 61j are connected to the connection portions 55 of the nozzles 23b to 23j, respectively.

The plurality of pipes 61 is not in contact with each other. The plurality of pipes 61 is separated from each other. For example, the pipe 61e is not in contact with any of the pipes 61a to 61d and 61f to 61j.

When the nozzles 23 are on standby in the nozzle standby section 59, the plurality of pipes 61 is arranged in the front-rear direction X.

Although not illustrated, each of the upstream end portions 62 extends in the width direction Y. The plurality of upstream end portions 62 is parallel to each other. The plurality of upstream end portions 62 is arranged in the front-rear direction X.

When the nozzle 23 is on standby in the nozzle standby section 59, the upstream end portion 62 overlaps the nozzle 23 in plan view. For example, when the nozzle 23a is on standby in the nozzle standby section 59, the upstream end portion 62 of the pipe 61a overlaps the nozzle 23a in plan view.

Although not illustrated, each of the upstream portions 63 extends in the width direction Y. The plurality of upstream portions 63 is parallel to each other. The plurality of upstream portions 63 is arranged in the front-rear direction X.

When the nozzles 23 are located in the nozzle standby section 59, the plurality of first bent portions 64 is arranged in the front-rear direction X.

When the nozzles 23 are on standby in the nozzle standby section 59, each of the downstream portions 65 extends in the width direction Y. When the nozzles 23 are on standby in the nozzle standby section 59, each of the downstream portions 65 extends in the first width direction from the first bent portion 64. For example, when the nozzle 23a is on standby in the nozzle standby section 59, the downstream portion 65 of the pipe 61a extends in the first width direction from the first bent portion 64 of the pipe 61a. When the nozzles 23 are on standby in the nozzle standby section 59, the plurality of downstream portions 65 is parallel to each other. When the nozzles 23 are on standby in the nozzle standby section 59, the plurality of downstream portions 65 is arranged in the front-rear direction X.

When the nozzle 23 is on standby in the nozzle standby section 59, the downstream portion 65 overlaps with the upstream portion 63 in plan view. For example, when the nozzle 23a is on standby in the nozzle standby section 59, the downstream portion 65 of the pipe 61a overlaps the upstream portion 63 of the pipe 61a in plan view.

When the nozzles 23 are on standby in the nozzle standby section 59, each of the downstream end portions 66 extends in the width direction Y. When the nozzles 23 are on standby in the nozzle standby section 59, each of the downstream end portions 66 extends in the first width direction from the downstream portion 65. For example, when the nozzle 23a is on standby in the nozzle standby section 59, the downstream end portion 66 of the pipe 61a extends in the first width direction from the downstream portion 65 of the pipe 61a. When the nozzles 23 are on standby in the nozzle standby section 59, the plurality of downstream end portions 66 is parallel to each other. When the nozzles 23 are on standby in the nozzle standby section 59, the plurality of downstream end portions 66 is arranged in the front-rear direction X.

When the nozzle 23 is on standby in the nozzle standby section 59, the downstream end portion 66 overlaps the upstream portion 63 in plan view. For example, when the nozzle 23a is on standby in the nozzle standby section 59, the downstream end portion 66 of the pipe 61a overlaps the upstream portion 63 of the pipe 61a in plan view.

When the nozzle 23 is located in the nozzle standby section 59, a bent portion included in the pipe 61 is only the first bent portion 64. When the nozzle 23 is located in the nozzle standby section 59, the number of bent portions included in the pipe 61 is one. For example, when the nozzle 23a is located in the nozzle standby section 59, a bent portion included in the pipe 61a is only the first bent portion 64 of the pipe 61a. When the nozzle 23a is located in the nozzle standby section 59, the number of bent portions included in the pipe 61a is one.

For example, the substrate rotation axis D passes through the center of the substrate holder 22 in plan view. Although illustration of the substrate W is omitted in FIG. 6, for example, the substrate rotation axis D passes through the center of the substrate W held by the substrate holder 22 in plan view.

The substrate rotation axis D of the substrate holder 22a is referred to as a "substrate rotation axis Da". The substrate rotation axis D of the substrate holder 22b is referred to as a "substrate rotation axis Db".

The position of the dispensing port 54 for dispensing the processing solution to the substrate W held by the substrate holder 22a is defined as a processing position Qa. For example, the processing position Qa overlaps the substrate holder 22a in plan view. The processing position Qa is located on the substrate rotation axis Da.

The position of the dispensing port 54 for dispensing the processing solution to the substrate W held by the substrate holder 22b is defined as a processing position Qb. For example, the processing position Qb overlaps the substrate holder 22b in plan view. The processing position Qb is located, for example, on the substrate rotation axis Db.

The dispensing port 54 of the nozzle 23a moves to the processing position Qa and the processing position Qb. The dispensing ports 54 of the nozzles 23b to 23j move to the processing position Qa and the processing position Qb, respectively.

The nozzles 23 are movable independently of each other. For example, only the nozzle 23a can move to the processing position Qa, while the nozzles 23b to 23j do not move to the processing position Qa.

In a case where the processing positions Qa to Qb are not distinguished, they are referred to as processing positions Q. Each dispensing port 54 moves between the standby position P and the processing position Q.

The pipes 61 are movable independently of each other. For example, only the pipe 61a is movable, while the pipes 61b to 61j do not move.

The downstream end portions 66 of the pipes 61 are movable independently of each other. For example, only the downstream end portion 66 of the pipe 61a is movable, while the downstream end portions 66 of the pipes 61b to 61j do not move.

The pipe 61 moves following the nozzle 23. For example, when the nozzle 23a moves, the pipe 61a moves.

The downstream end portion 66 of the pipe 61 moves following the nozzle 23. For example, when the nozzle 23a moves, the downstream end portion 66 of the pipe 61a moves.

FIG. 6 illustrates a virtual plane Ke. The virtual plane Ke is a virtual plane. The virtual plane Ke is defined by the upstream end portion 62 of the pipe 61e. Although the upstream end portion 62 of the pipe 61e is not illustrated in FIG. 6, the virtual plane Ke includes the upstream end portion 62 of the pipe 61e. Moreover, the virtual plane Ke is vertical. Since the upstream end portion 62 extends in the width direction Y, the virtual plane Ke is parallel to the width direction Y and parallel to the vertical direction Z. In other words, the virtual plane Ke is orthogonal to the front-rear direction X.

The nozzle standby section 59 is located on the virtual plane Ke in plan view. When the nozzle 23e is located in the nozzle standby section 59, the nozzle 23e is located on the virtual plane Ke in plan view.

The standby position Pe is located on the virtual plane Ke in plan view. When the nozzle 23e is located in the nozzle standby section 59, the dispensing port 54 of the nozzle 23e is located on the virtual plane Ke in plan view.

The connection portion 55 is located on the virtual plane Ke in plan view. When the nozzle 23e is located in the nozzle standby section 59, the connection portion 55 of the nozzle 23e is located on the virtual plane Ke in plan view.

The dispensing port 54 of the nozzle 23 is located on an extension of the connection portion 55 of the nozzle 23 in plan view. For example, the dispensing port 54 of the nozzle 23e is located on an extension of the connection portion 55 of the nozzle 23e in plan view.

Although not illustrated, when the nozzle 23e is located in the nozzle standby section 59, the upstream portion 63 of the pipe 61e is located on the virtual plane Ke in plan view.

When the nozzle 23e is located in the nozzle standby section 59, the first bent portion 64 of the pipe 61e is located on the virtual plane Ke in plan view. When the nozzle 23e is located in the nozzle standby section 59, the downstream portion 65 of the pipe 61e is located on the virtual plane Ke in plan view.

When the nozzle 23e is located in the nozzle standby section 59, the downstream end portion 66 of the pipe 61e is located on the virtual plane Ke in plan view.

The dispensing port 54 of the nozzle 23 is located on an extension of the downstream end portion 66 of the pipe 61 connected to the nozzle 23 in plan view. For example, the dispensing port 54 of the nozzle 23e is located on an extension of the downstream end portion 66 of the pipe 61e in plan view.

The processing position Qa is shifted in the front-rear direction X from the virtual plane Ke in plan view. The processing position Qa is not located on the virtual plane Ke in plan view. For example, the processing position Qa is shifted in the front direction from the virtual plane Ke in plan view.

The processing position Qb is shifted in the front-rear direction X from the virtual plane Ke in plan view. The processing position Qb is not located on the virtual plane Ke in plan view. For example, the processing position Qb is shifted in the rear direction from the virtual plane Ke in plan view.

FIG. 6 further illustrates a virtual plane Ka. The virtual plane Ka is a virtual plane. The virtual plane Ka is similar to the virtual plane Ke. The virtual plane Ka is defined by the upstream end portion 62 of the pipe 61a. The positional relationship among the virtual plane Ka, the nozzle 23a, and the pipe 61a is the same as the positional relationship among the virtual plane Ke, the nozzle 23e, and the pipe 61e.

In a case where the virtual planes Ka and Ke are not distinguished, the virtual planes Ka and Ke are referred to as virtual planes K.

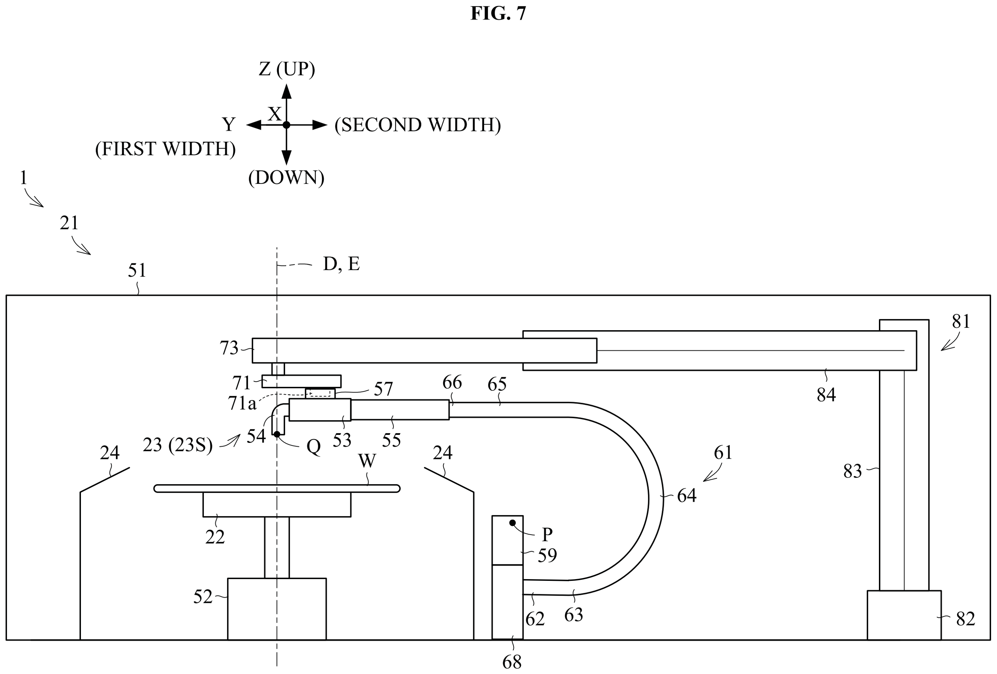

FIG. 7 is a side view of the coating processing unit 21. The nozzle 23 is located at the processing position Q. The processing position Q is disposed above the substrate W held by the substrate holder 22. For example, the processing position Qa is disposed above the substrate W held by the substrate holder 22a. The processing position Qb is disposed above the substrate W held by the substrate holder 22b.

The width direction Y is an example of a first direction of the present invention. The front-rear direction X is an example of a second direction of the present invention. One of the substrate holders 22a and 22b is an example of a first substrate holder of the present invention. The other of the substrate holders 22a and 22b is an example of a second substrate holder of the present invention. One of the processing positions Qa and Qb is an example of a first processing position of the present invention. The other of the processing positions Qa and Qb is an example of a second processing position of the present invention.

Refer to FIGS. 5 and 7. The coating processing unit 21 includes a nozzle holder 71. The nozzle holder 71 holds any one of the nozzles 23. The nozzle holder 71 selectively holds any one of the nozzles 23. The nozzle holder 71 holds one nozzle 23 at a time. For example, when the nozzle holder 71 holds the nozzle 23a, the nozzle holder 71 does not hold the nozzles 23b to 23j.

The nozzle holder 71 is separable from the nozzle 23. For example, after the nozzle holder 71 holds the nozzle 23a, the nozzle holder 71 can be separated from the nozzle 23a.

Specifically, the nozzle holder 71 is engaged with and disengaged from any one of the nozzles 23. The nozzle holder 71 is engaged with and disengaged from any one of the engagement portions 57.

For example, the nozzle holder 71 includes a holding piece 71a. The holding piece 71a is engaged with the engagement portion 57. Although not illustrated, the holding piece 71a is inserted into the recess of the engagement portion 57 described above. The holding piece 71a is engaged with the side wall of the engagement portion 57 described above. The holding piece 71a is concavo-convexly coupled to the side wall of the engagement portion 57.

The nozzle holder 71 does not support the pipe 61. The nozzle holder 71 is not in contact with the pipe 61. For example, even when the nozzle holder 71 holds the nozzle 23a, the nozzle holder 71 does not support the pipe 61a. Even when the nozzle holder 71 holds the nozzle 23a, the nozzle holder 71 does not come into contact with the pipe 61a.

Hereinafter, the nozzle 23 held by the nozzle holder 71 is referred to as a selection nozzle 23S. For example, when the nozzle holder 71 holds the nozzle 23a, the nozzle 23a is the selection nozzle 23S, and none of the nozzles 23b to 23j is the selection nozzle 23S.

A virtual plane K defined by the upstream end portion 62 of the pipe 61 connected to the selection nozzle 23S is defined as a selection virtual plane KS. The selection virtual plane KS includes the upstream end portion 62 of the pipe 61 connected to the selection nozzle 23S.

The coating processing unit 21 includes an arm 73. The arm 73 is coupled to the nozzle holder 71. The arm 73 supports the nozzle holder 71.

When the nozzle holder 71 holds the nozzle 23, the arm 73 supports the nozzle 23 held by the nozzle holder 71. That is, the arm 73 supports the selection nozzle 23S.

The arm 73 does not support the pipe 61. The arm 73 is not in contact with the pipe 61. For example, even when the arm 73 holds the selection nozzle 23S, the arm 73 does not support the pipe 61 connected to the selection nozzle 23S. Even when the arm 73 holds the selection nozzle 23S, the arm 73 does not come into contact with the pipe 61 connected to the selection nozzle 23S.

The selection nozzle 23S is rotatable about a rotation axis E with respect to the arm 73.

The rotation axis E is defined by the selection nozzle 23S. The rotation axis E passes through the dispensing port 54 of the selection nozzle 23S. The dispensing port 54 of the selection nozzle 23S is disposed on the rotation axis E.

The rotation axis E extends in the vertical direction Z.

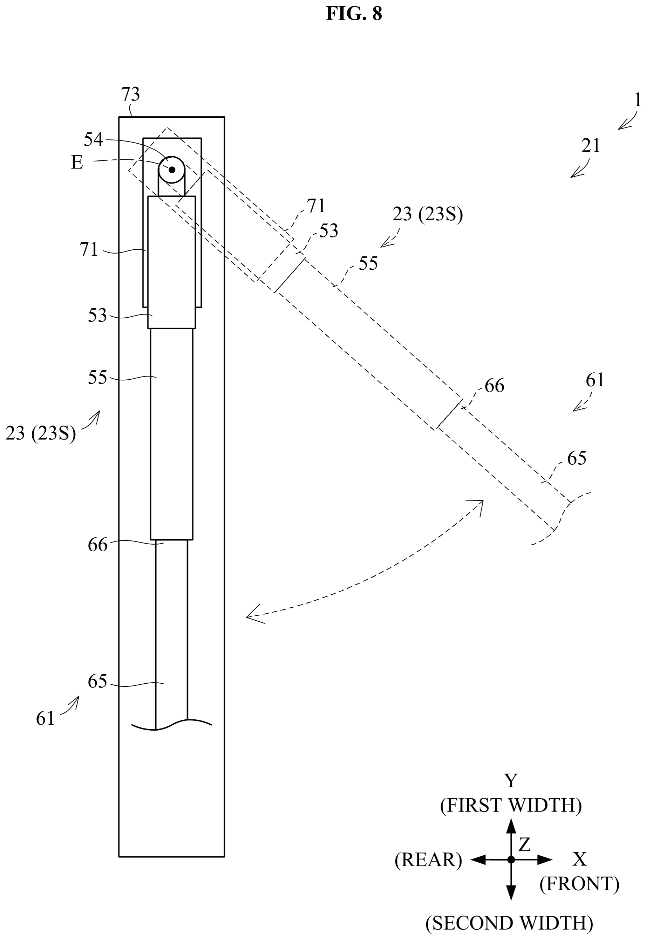

FIG. 8 is a bottom view of the selection nozzle 23S, the nozzle holder 71, and the arm 73. For example, the nozzle holder 71 is rotatable about the rotation axis E with respect to the arm 73. The selection nozzle 23S is rotatable about the rotation axis E with respect to the arm 73 integrally with the nozzle holder 71.

As described above, the rotation axis E passes through the dispensing port 54 of the selection nozzle 23S. Therefore, even when the selection nozzle 23S rotates about the rotation axis E with respect to the arm 73, the position of the dispensing port 54 of the selection nozzle 23S does not substantially change. Accordingly, the position of the dispensing port 54 of the selection nozzle 23S does not depend on the rotation of the selection nozzle 23S about the rotation axis E with respect to the arm 73.

The relative position of the dispensing port 54 of the selection nozzle 23S with respect to the arm 73 does not change. The relative position of the dispensing port 54 of the selection nozzle 23S with respect to the arm 73 is constant. Therefore, the position of the dispensing port 54 of the selection nozzle 23S is determined by the position of the arm 73. When the arm 73 moves, the position of the dispensing port 54 of the selection nozzle 23S moves. When the arm 73 does not move, the position of the dispensing port 54 of the selection nozzle 23S does not move.

The rotation axis E passes through the arm 73. The arm 73 is disposed on the rotation axis E.

The dispensing port 54 of the selection nozzle 23S overlaps the arm 73 in plan view. The entire dispensing port 54 of the selection nozzle 23S overlaps the arm 73 in plan view.

The connection portion 55 of the selection nozzle 23S is rotatable about the rotation axis E with respect to the arm 73. The relative position of the connection portion 55 of the selection nozzle 23S with respect to the arm 73 can be changed. The orientation of the connection portion 55 of the selection nozzle 23S can be changed.

The relative position of the connection portion 55 of the selection nozzle 23S with respect to the arm 73 is determined by the orientation of the connection portion 55 of the selection nozzle 23S, and the position of the arm 73.

The connection portion 55 of the selection nozzle 23S extends in the radial direction of the rotation axis E. The connection portion 55 of the selection nozzle 23S extends in a direction orthogonal to the rotation axis E.

The downstream end portion 66 of the pipe 61 connected to the selection nozzle 23S is rotatable about the rotation axis E with respect to the arm 73. The relative position of the downstream end portion 66 of the pipe 61 connected to the selection nozzle 23S with respect to the arm 73 can be changed. The orientation of the downstream end portion 66 of the pipe 61 connected to the selection nozzle 23S can be changed.

The downstream end portion 66 of the pipe 61 connected to the selection nozzle 23S extends in the radial direction of the rotation axis E. The downstream end portion 66 of the pipe 61 connected to the selection nozzle 23S extends in a direction orthogonal to the rotation axis E.

Refer to FIGS. 4, 5, and 7. The coating processing unit 21 includes an arm drive section 81. The arm drive section 81 is coupled to the arm 73. The arm drive section 81 moves the arm 73. The arm drive section 81 moves the arm 73 in, for example, the horizontal direction and the vertical direction Z.

The arm drive section 81 moves the selection nozzle 23S. The arm drive section 81 moves the selection nozzle 23S to the nozzle standby section 59. The arm drive section 81 moves the selection nozzle 23S to the substrate holder 22.

The arm drive section 81 moves the dispensing port 54 of the selection nozzle 23S. The arm drive section 81 moves the dispensing port 54 of the selection nozzle 23S to the processing position Q. The arm drive section 81 moves the dispensing port 54 of the selection nozzle 23S to the standby position P.

The arm drive section 81 determines the position of the arm 73. The position of the arm 73 is obtained by the operation of the arm drive section 81.

The arm drive section 81 determines the position of the dispensing port 54 of the selection nozzle 23S. The position of the dispensing port 54 of the selection nozzle 23S is obtained by the operation of the arm drive section 81.

However, the arm drive section 81 cannot rotate the selection nozzle 23S about the rotation axis E with respect to the arm 73. The rotation of the selection nozzle 23S about the rotation axis E with respect to the arm 73 is independent of the movement of the arm 73 by the arm drive section 81. The rotation of the selection nozzle 23S about the rotation axis E with respect to the arm 73 does not depend on the arm drive section 81.

An example of a configuration of the arm drive section 81 will be described. The arm drive section 81 includes a base 82, a horizontal movement section 83, and a vertical movement section 84. The base 82 is fixedly installed. The base 82 is fixed to the housing 51. The substrate holder 22, the nozzle standby section 59, and the base 82 are arranged in this order in the width direction Y. The base 82 is disposed at a position lower than the arm 73. The base 82 is fixed to the bottom plate of the housing 51. The base 82 extends in the front-rear direction X. The horizontal movement section 83 is supported by the base 82. The horizontal movement section 83 extends upward from the base 82. The horizontal movement section 83 moves in the front-rear direction X with respect to the base 82. The vertical movement section 84 is supported by the horizontal movement section 83. The vertical movement section 84 moves in the vertical direction Z with respect to the horizontal movement section 83. The vertical movement section 84 supports the arm 73. The vertical movement section 84 moves the arm 73 in the width direction Y.

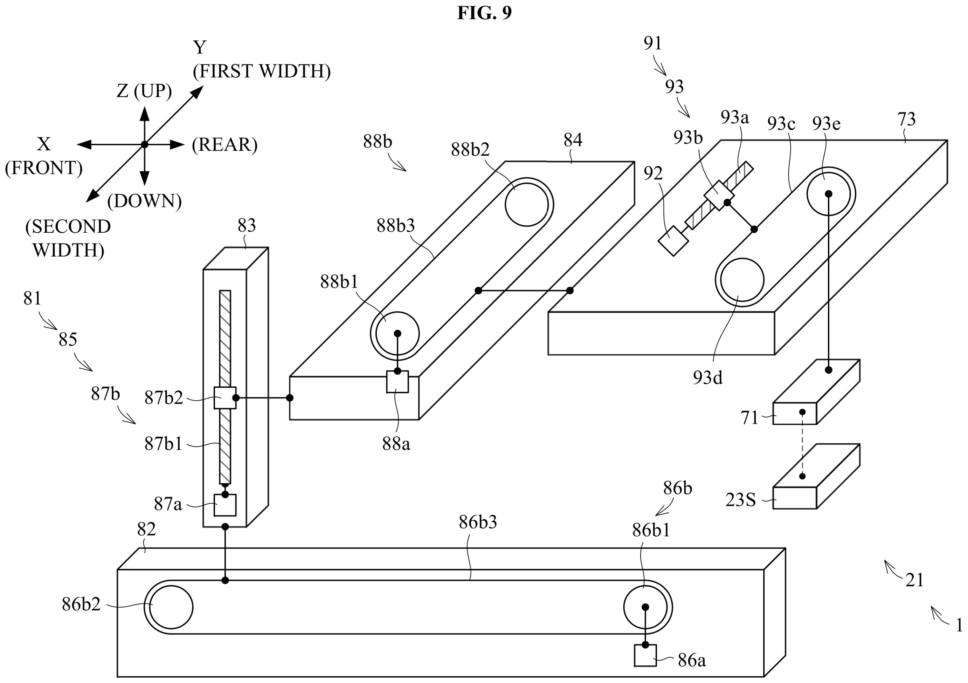

FIG. 9 is a diagram schematically illustrating the arm drive section 81. The arm drive section 81 includes an actuator 85. The actuator 85 moves the horizontal movement section 83, the vertical movement section 84, and the arm 73.

The actuator 85 includes a first power source 86a and a first power transmission portion 86b. The first power source 86a and the first power transmission portion 86b move the horizontal movement section 83 with respect to the base 82. The first power source 86a is, for example, an electric motor. The first power transmission portion 86b includes a driving pulley 86b1, a driven pulley 86b2, and a belt 86b3. The driving pulley 86b1 is coupled to the first power source 86a. The belt 86b3 is hooked on the driving pulley 86b1 and the driven pulley 86b2. The belt 86b3 extends in the front-rear direction X. The horizontal movement section 83 is coupled to the belt 86b3. The first power source 86a rotates the driving pulley 86b1. When the driving pulley 86b1 rotates, the belt 86b3 travels in the front-rear direction X. When the belt 86b3 travels in the front-rear direction X, the horizontal movement section 83 moves in the front-rear direction X with respect to the base 82. The first power transmission portion 86b may further include a guide that guides the horizontal movement section 83 in the front-rear direction X. The guide is, for example, a linear guide rail.

The actuator 85 includes a second power source 87a and a second power transmission portion 87b. The second power source 87a and the second power transmission portion 87b move the vertical movement section 84 with respect to the horizontal movement section 83. The second power source 87a is, for example, an electric motor. The second power transmission portion 87b includes a screw shaft 87b1 and a nut 87b2. The screw shaft 87b1 is coupled to the second power source 87a. The screw shaft 87b1 extends in the vertical direction Z. The nut 87b2 is screwed to the screw shaft 87b1. Even when the screw shaft 87b1 rotates, the nut 87b2 does not rotate about the screw shaft 87b1. The vertical movement section 84 is coupled to the nut 87b2. The second power source 87a rotates the screw shaft 87b1. When the screw shaft 87b1 rotates, the nut 87b2 moves in the vertical direction Z with respect to the screw shaft 87b1. When the nut 87b2 moves in the vertical direction Z with respect to the screw shaft 87b1, the vertical movement section 84 moves in the vertical direction Z with respect to the horizontal movement section 83. The second power transmission portion 87b may further include a guide that guides the vertical movement section 84 in the vertical direction Z. The guide is, for example, a linear guide rail.

The actuator 85 includes a third power source 88a and a third power transmission portion 88b. The third power source 88a and the third power transmission portion 88b move the arm 73 with respect to the vertical movement section 84. The third power source 88a is, for example, an electric motor. The third power transmission portion 88b includes a driving pulley 88b1, a driven pulley 88b2, and a belt 88b3. The driving pulley 88b1 is coupled to the third power source 88a. The belt 88b3 is hooked on the driving pulley 88b1 and the driven pulley 88b2. The belt 88b3 extends in the width direction Y. The arm 73 is coupled to the belt 88b3. The third power source 88a rotates the driving pulley 88b1. When the driving pulley 88b1 rotates, the belt 88b3 travels in the width direction Y. When the belt 88b3 travels in the width direction Y, the arm 73 moves in the width direction Y with respect to the vertical movement section 84. The third power transmission portion 88b may further include a guide that guides the arm 73 in the width direction Y. The guide is, for example, a linear guide rail.

The coating processing section 21 includes a nozzle rotation drive section 91. The nozzle rotation drive section 91 rotates the selection nozzle 23S about the rotation axis E with respect to the arm 73. For example, the nozzle rotation drive section 91 rotates the nozzle holder 71 about the rotation axis E with respect to the arm 73.

The nozzle rotation drive section 91 includes a power source 92 and a power transmission portion 93. The power source 92 is, for example, an electric motor. The power transmission portion 93 includes a screw shaft 93a, a nut 93b, a belt 93c, a pulley 93d, and a pulley 93e. The screw shaft 93a is coupled to the power source 92. The nut 93b is screwed to the screw shaft 93a. Even when the screw shaft 93a rotates, the nut 93b does not rotate about the screw shaft 93a. The belt 93c is coupled to the nut 93b. The belt 93c is hooked on the pulley 93d and the pulley 93e. The pulley 93e is rotatable about the rotation axis E. The nozzle holder 71 is coupled to the pulley 93e. The power source 92 rotates the screw shaft 93a. When the screw shaft 93a rotates, the nut 93b moves with respect to the screw shaft 93a. Specifically, when the screw shaft 93a rotates, the nut 93b moves along an axis of the screw shaft 93a. When the nut 93b moves with respect to the screw shaft 93a, the belt 93c travels. When the belt 93c travels, the pulley 93e rotates about the rotation axis E. When the pulley 93e rotates about the rotation axis E, the nozzle holder 71 rotates about the rotation axis E with respect to the arm 73.

Refer to FIG. 3. The controller 8 controls the coating processing unit 21. Specifically, the controller 8 controls the substrate rotation drive section 52. The controller 8 controls the arm drive section 81. Although not illustrated, the controller 8 controls the actuator 85. Although not illustrated, the controller 8 controls the first power source 86a, the second power source 87a, and the third power source 88a. The controller 8 controls the nozzle rotation drive section 91. Although not illustrated, the controller 8 controls the power source 92.

For example, the controller 8 controls the nozzle rotation drive section 91 on the basis of the position of the dispensing port 54 of the selection nozzle 23S.

For example, the controller 8 acquires the position of the dispensing port 54 of the selection nozzle 23S on the basis of the operation of the arm drive section 81.

For example, the controller 8 has nozzle conveyance information. The nozzle conveyance information is stored in advance in a storage medium of the controller 8. The nozzle conveyance information defines a procedure of conveyance of the nozzle 23. The controller 8 controls the arm drive section 81 and the nozzle rotation drive section 91 on the basis of the nozzle conveyance information.

### <3. Operation example of coating processing unit 21>

The coating processing unit 21 operates under the control of the controller 8.

A first operation example, a second operation example, and a third operation example will be described. In the first operation example, the nozzle 23e moves between the nozzle standby section 59 and the substrate holder 22b. In the second operation example, the nozzle 23e is moved between the nozzle standby section 59 and the substrate holder 22a. In the third operation example, the nozzle 23a is moved between the nozzle standby section 59 and the substrate holder 22b.

In the first to third operation examples, one of the nozzles 23a and 23e is an example of a first nozzle of the present invention. The other of the nozzles 23a and 23e is an example of a second nozzle of the present invention.

### <3-1. First operation example>

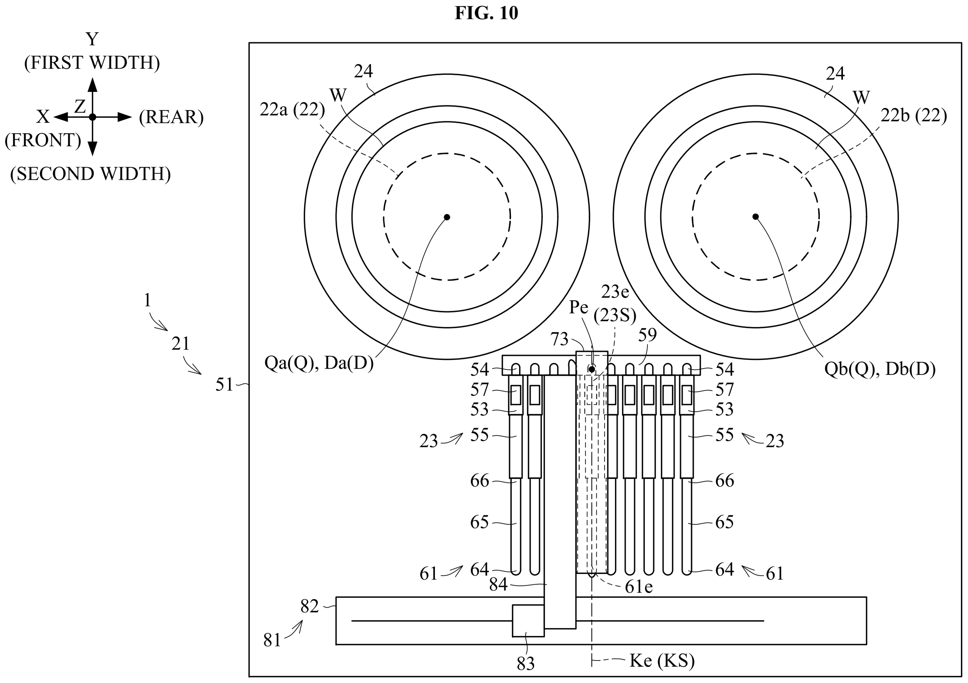

FIG. 10 is a plan view of the coating processing unit 21. In the first operation example, the nozzle 23e is the selection nozzle 23S. In the first operation example, the pipe 61e is the pipe 61 connected to the selection nozzle 23S. In the first operation example, the virtual plane Ke is the selection virtual plane KS.

The nozzle 23e is located in the nozzle standby section 59. The dispensing port 54 of the nozzle 23e is located at the standby position Pe. The arm drive section 81 moves the arm 73 to the nozzle standby section 59.

Although the nozzle holder 71 is not illustrated in FIG. 10, the arm drive section 81 moves the nozzle holder 71 to the nozzle standby section 59. Then, the nozzle holder 71 holds the nozzle 23e. Specifically, the nozzle holder 71 engages with the engagement portion 57 of the nozzle 23e. After the nozzle holder 71 holds the nozzle 23e, the arm drive section 81 may move the nozzle 23e upward from the nozzle standby section 59.

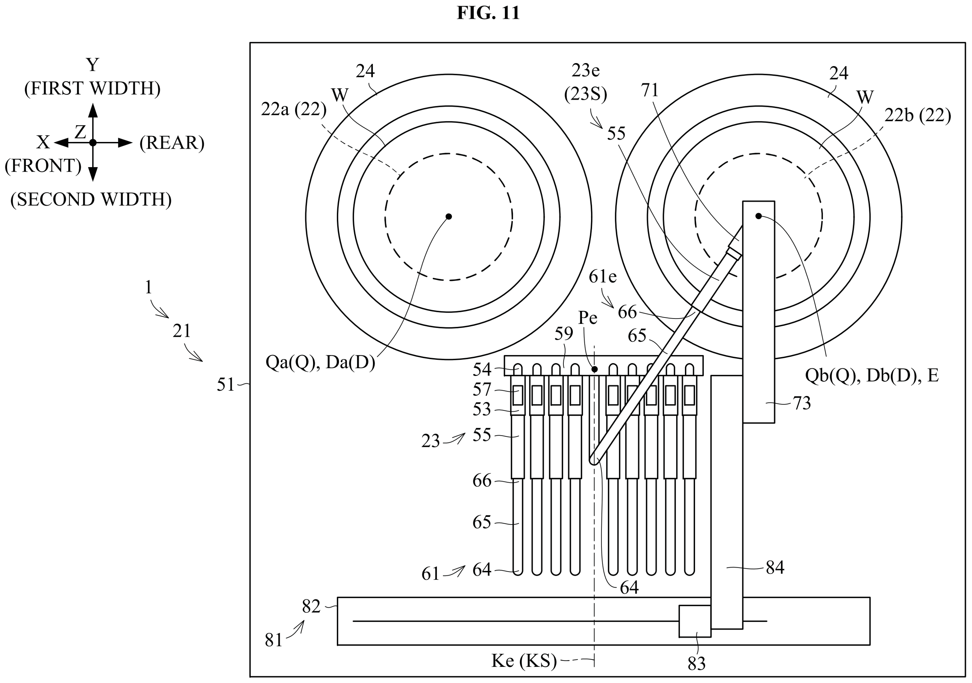

FIG. 11 is a plan view of the coating processing unit 21. The arm drive section 81 moves the arm 73 from the nozzle standby section 59 to the substrate holder 22b. The arm drive section 81 moves the nozzle holder 71 from the nozzle standby section 59 to the substrate holder 22b. The arm drive section 81 moves the nozzle 23e from the nozzle standby section 59 to the substrate holder 22b. The arm drive section 81 moves the dispensing port 54 of the nozzle 23e from the standby position Pe to the processing position Qb.

Moreover, the nozzle rotation drive section 91 rotates the nozzle 23e about the rotation axis E with respect to the arm 73.

Thereafter, the dispensing port 54 of the nozzle 23e stops at the processing position Qb. The dispensing port 54 of the nozzle 23e dispenses the processing solution from the processing position Qb.

When the dispensing port 54 of the nozzle 23e is located at the processing position Qb, the bent portion included in the pipe 61e is only the first bent portion 64 of the pipe 61e. When the dispensing port 54 of the nozzle 23e is located at the processing position Qb, the number of bent portions included in the pipe 61e is one.

The nozzle 23e rotates about the rotation axis E with respect to the arm 73 so that the number of bent portions included in the pipe 61e is one. The nozzle 23e rotates about the rotation axis E with respect to the arm 73 so that the number of bent portions included in the pipe 61e does not increase to two or more. For example, the nozzle 23e rotates about the rotation axis E with respect to the arm 73 so that the number of bent portions included in the pipe 61e is one when the dispensing port 54 of the nozzle 23e is located at the processing position Qb.

When the dispensing port 54 of the nozzle 23e is located at the processing position Qb, the connection portion 55 of the nozzle 23e is directed to the first bent portion 64 of the pipe 61e.

The nozzle 23e rotates about the rotation axis E with respect to the arm 73 so that the connection portion 55 of the nozzle 23e is directed to the first bent portion 64 of the pipe 61e. For example, the nozzle 23e rotates about the rotation axis E with respect to the arm 73 so that the connection portion 55 of the nozzle 23e is directed to the first bent portion 64 of the pipe 61e when the dispensing port 54 of the nozzle 23e is located at the processing position Qb.

When the dispensing port 54 of the nozzle 23e is located at the processing position Qb, the downstream end portion 66 of the pipe 61e is directed to the first bent portion 64 of the pipe 61e.

The nozzle 23e rotates about the rotation axis E with respect to the arm 73 so that the downstream end portion 66 of the pipe 61e is directed to the first bent portion 64 of the pipe 61e. For example, the nozzle 23e rotates about the rotation axis E with respect to the arm 73 so that the downstream end portion 66 of the pipe 61e is directed to the first bent portion 64 of the pipe 61e when the dispensing port 54 of the nozzle 23e is located at the processing position Qb.

When the dispensing port 54 of the nozzle 23e is located at the processing position Qb, the first bent portion 64 of the pipe 61e is located on the virtual plane Ke in plan view.

The nozzle 23e rotates about the rotation axis E with respect to the arm 73 so that the first bent portion 64 of the pipe 61e is located on the virtual plane Ke in plan view when the dispensing port 54 of the nozzle 23e is located at the processing position Qb.

When the dispensing port 54 of the nozzle 23e is located at the processing position Qb, the first bent portion 64 of the pipe 61e is not excessively shifted in the front-rear direction X from the virtual plane Ke in plan view.

The nozzle 23e rotates about the rotation axis E with respect to the arm 73 so as to suppress the first bent portion 64 of the pipe 61e from being shifted in the front-rear direction X from the virtual plane Ke in plan view. For example, the nozzle 23e rotates about the rotation axis E with respect to the arm 73 so as to suppress the first bent portion 64 of the pipe 61e from being shifted in the front-rear direction X from the virtual plane Ke in plan view when the dispensing port 54 of the nozzle 23e is located at the processing position Qb.

Here, "suppressing the first bent portion 64 of the pipe 61e from being shifted in the front-rear direction X from the virtual plane Ke in plan view" means, for example, suppressing the first bent portion 64 of the pipe 61e from swelling in the front-rear direction X from the virtual plane Ke in plan view. "Suppressing the first bent portion 64 of the pipe 61e from being shifted in the front-rear direction X from the virtual plane Ke in plan view" means, for example, suppressing the first bent portion 64 of the pipe 61e from moving in the front-rear direction X from the virtual plane Ke in plan view.

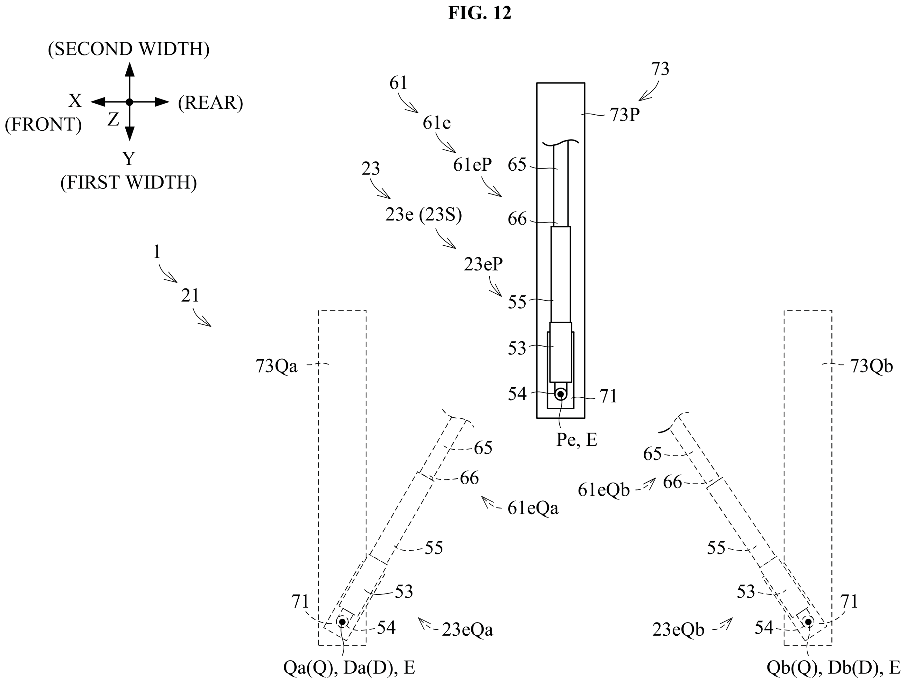

FIG. 12 is a bottom view of the nozzle 23 and the arm 73. FIG. 12 illustrates a nozzle 23eP, a pipe 61eP, and an arm 73P with solid lines. The nozzle 23eP is a nozzle 23e including the dispensing port 54 located at the standby position Pe. In other words, the nozzle 23e when the dispensing port 54 of the nozzle 23e is located at the standby position Pe is referred to as "nozzle 23eP". The pipe 61eP is a pipe 61e connected to the nozzle 23eP. In other words, the pipe 61e when the nozzle 23e is the nozzle 23eP is referred to as "pipe 61eP". The arm 73P is the arm 73 that supports the nozzle 23eP. In other words, the arm 73 that supports the nozzle 23e when the nozzle 23e is the nozzle 23eP is referred to as "arm 73P".

FIG. 12 illustrates a nozzle 23eQb, a pipe 61eQb, and an arm 73Qb with broken lines. The nozzle 23eQb is the nozzle 23e including the dispensing port 54 located at the processing position Qb. In other words, the nozzle 23e when the dispensing port 54 of the nozzle 23e is located at the processing position Qb is referred to as "nozzle 23eQb". The pipe 61eQb is the pipe 61e connected to the nozzle 23eQb. In other words, the pipe 61e when the nozzle 23e is the nozzle 23eQb is referred to as "pipe 61eQb". The arm 73Qb is the arm 73 that supports the nozzle 23eQb. In other words, the arm 73 that supports the nozzle 23e when the nozzle 23e is the nozzle 23eQb is referred to as the "arm 73Qb".

The orientation of the connection portion 55 of the nozzle 23eQb is different from the orientation of the connection portion 55 of the nozzle 23eP.

The orientation of the downstream end portion 66 of the pipe 61eQb is different from the orientation of the downstream end portion 66 of the pipe 61eP.

The relative position of the connection portion 55 of the nozzle 23eQb with respect to the arm 73Qb is different from the relative position of the connection portion 55 of the nozzle 23eP with respect to the arm 73P.

The relative position of the downstream end portion 66 of the pipe 61eQb with respect to the arm 73Qb is different from the relative position of the downstream end portion 66 of the pipe 61eP with respect to the arm 73P.

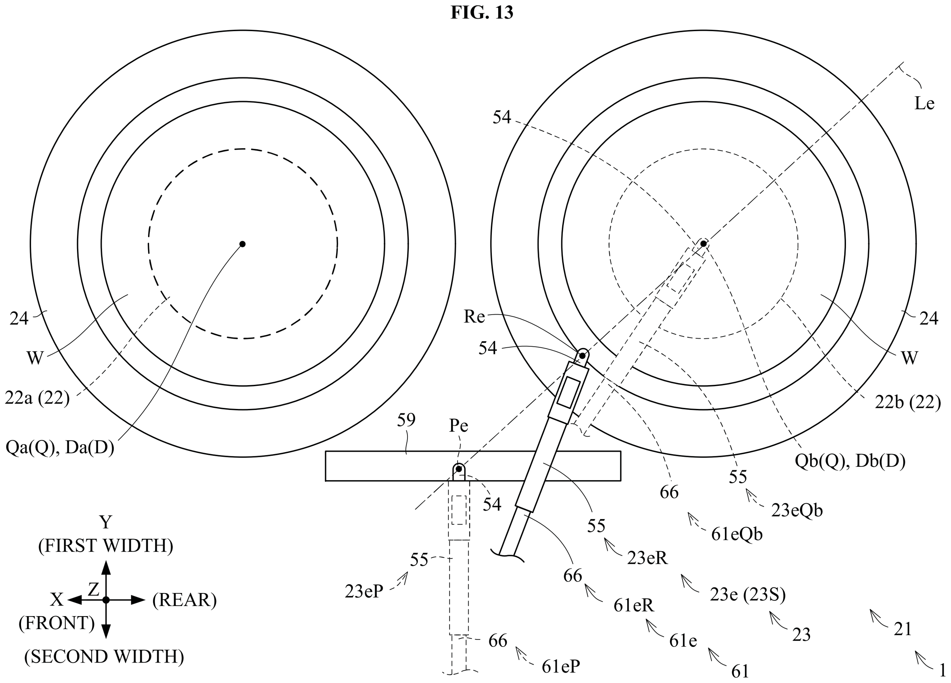

FIG. 13 is a plan view of the coating processing unit 21. For example, the arm drive section 81 linearly moves the dispensing port 54 of the nozzle 23e in plan view. The arm drive section 81 linearly moves the dispensing port 54 of the nozzle 23e from the standby position Pe to the processing position Qb in plan view.

FIG. 13 illustrates a virtual line Le. The virtual line Le is a virtual straight line. The virtual line Le is defined by the standby position Pe and the processing position Qb. The virtual line Le connects the standby position Pe and the processing position Qb.

The dispensing port 54 of the nozzle 23e moves along the virtual line Le in plan view. Specifically, the arm drive section 81 moves the dispensing port 54 of the nozzle 23e along the virtual line Le in plan view.

The standby position Pe is an example of a first standby position of the present invention. The processing position Qb is an example of a first processing position of the present invention. The virtual line Le is an example of a first virtual line of the present invention.

FIG. 13 illustrates a nozzle 23eR and a pipe 61eR with solid lines. The nozzle 23eR is the nozzle 23e including the dispensing port 54 located at an intermediate position Re. In other words, the nozzle 23e when the dispensing port 54 of the nozzle 23e is located at the intermediate position Re is referred to as "nozzle 23eR". The intermediate position Re is disposed between the standby position Pe and the processing position Qb. The intermediate position Re is located on the virtual line Le in plan view. The pipe 61eR is the pipe 61e connected to the nozzle 23eR. In other words, the pipe 61e when the nozzle 23e is the nozzle 23eR is referred to as "pipe 61eR".

Moreover, FIG. 13 illustrates the nozzle 23eP and the pipe 61eP with broken lines. FIG. 13 illustrates the nozzle 23eQb and the pipe 61eQb with broken lines.

When the dispensing port 54 of the nozzle 23e moves between the standby position Pe and the processing position Qb, the dispensing port 54 of the nozzle 23e passes through the intermediate position Re. For example, the dispensing port 54 of the selection nozzle 23S moves from the standby position Pe to the intermediate position Re, and then moves from the intermediate position Re to the processing position Qb.

The orientation of the connection portion 55 of the nozzle 23eR is different from the orientation of the connection portion 55 of the nozzle 23eP. The orientation of the connection portion 55 of the nozzle 23eR is different from the orientation of the connection portion 55 of the nozzle 23eQb.

The orientation of the downstream end portion 66 of the pipe 61eR is different from the orientation of the downstream end portion 66 of the pipe 61eP. The orientation of the downstream end portion 66 of the pipe 61eR is different from the orientation of the downstream end portion 66 of the pipe 61eQb.

When the arm drive section 81 moves the nozzle 23e, the nozzle 23e rotates about the rotation axis E with respect to the arm 73. While the arm drive section 81 moves the nozzle 23e, the nozzle 23e rotates about the rotation axis E with respect to the arm 73.

For example, the nozzle 23e rotates about the rotation axis E with respect to the arm 73 so that the number of bent portions of the pipe 61e connected to the nozzle 23e is one when the arm drive section 81 moves the nozzle 23e. For example, the nozzle 23e rotates about the rotation axis E with respect to the arm 73 so that the number of bent portions of the pipe 61e connected to the nozzle 23e does not increase to two or more when the arm drive section 81 moves the nozzle 23e.

For example, the nozzle 23e rotates about the rotation axis E with respect to the arm 73 so that the connection portion 55 of the nozzle 23e is directed to the first bent portion 64 of the pipe 61e when the arm drive section 81 moves the nozzle 23e.

For example, the nozzle 23e rotates about the rotation axis E with respect to the arm 73 so that the downstream end portion 66 of the pipe 61e is directed to the first bent portion 64 of the pipe 61e when the arm drive section 81 moves the nozzle 23e.

For example, when the arm drive section 81 moves the nozzle 23e, the nozzle 23e rotates about the rotation axis E with respect to the arm 73 so that the first bent portion 64 of the pipe 61e moves on the virtual plane Ke in plan view.

For example, when the arm drive section 81 moves the nozzle 23e, the nozzle 23e rotates about the rotation axis E with respect to the arm 73 so as to suppress the first bent portion 64 of the pipe 61e from being shifted in the front-rear direction X from the virtual plane Ke in plan view.

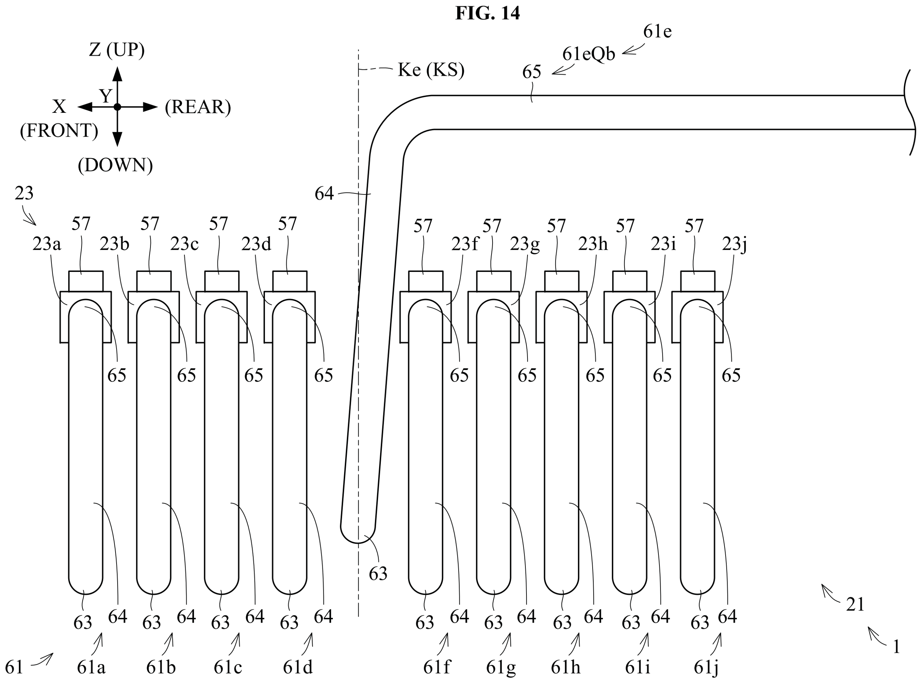

FIG. 14 is a side view of the pipe 61. Although the nozzle 23e is not illustrated in FIG. 14, the nozzle 23e is the above-described nozzle 23eQb. Specifically, the dispensing port 54 of the nozzle 23e is located at the processing position Qb. Therefore, in FIG. 14, the pipe 61e is the above-described pipe 61eQb.

The first bent portion 64 of the pipe 61eQb is slightly shifted from the virtual plane Ke. However, the first bent portion 64 of the pipe 61eQb is not excessively shifted from the virtual plane Ke. For example, a part of the first bent portion 64 of the pipe 61eQb is located on the virtual plane Ke.

Therefore, when the dispensing port 54 of the nozzle 23e is located at the processing position Qb, the pipe 61e does not come into contact with the other pipes 61a to 61d and 61f to 61j.

For example, the pipe 61e is adjacent to the pipe 61f. However, the pipe 61e is not in contact with the pipe 61f. Even when the dispensing port 54 of the nozzle 23e is located at the processing position Qb, the pipe 61e does not come into contact with the pipe 61f.

The pipe 61e is adjacent to the pipe 61d. However, the pipe 61e is not in contact with the pipe 61d. Even when the dispensing port 54 of the nozzle 23e is located at the processing position Qb, the pipe 61e does not come into contact with the pipe 61d.

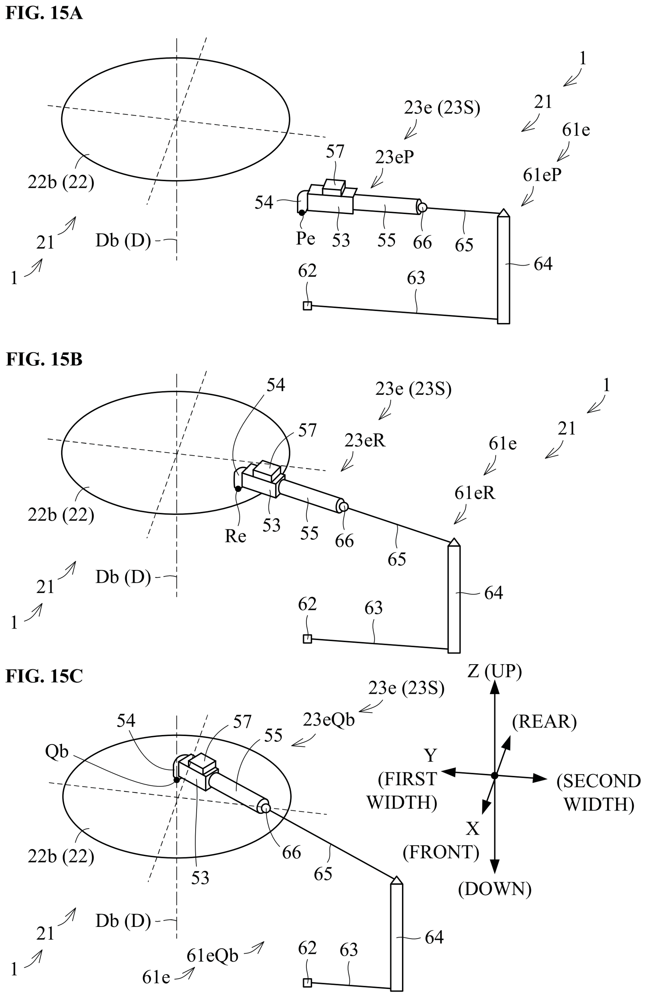

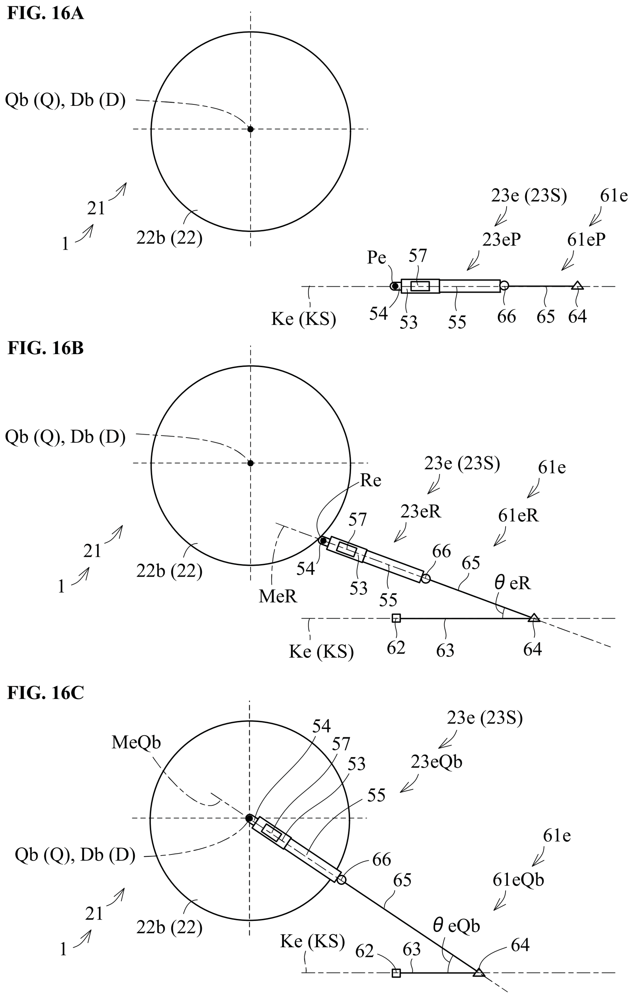

FIGS. 15A, 15B, and 15C are perspective views for describing the relationship between the nozzle 23e and the pipe 61e, respectively. FIGS. 16A, 16B, and 16C are plan views for describing the relationship between the nozzle 23e and the pipe 61e, respectively. FIGS. 15A to 15C and 16A to 16C illustrate the pipe 61e in a simple shape.

FIGS. 15A and 16A illustrate the nozzle 23eP and the pipe 61eP, respectively. FIGS. 15B and 16B illustrate the nozzle 23eR and the pipe 61eR, respectively. FIGS. 15C and 16C illustrate the nozzle 23eQb and the pipe 61eQb, respectively.

The relationship between the nozzle 23e and the pipe 61 is as follows. When the dispensing port 54 of the nozzle 23e moves from the standby position Pe to the processing position Qb, the length of the pipe 61e is constant. The length of the pipe 61e is the sum of the lengths of the upstream end portion 62, the upstream portion 63, the first bent portion 64, the downstream portion 65, and the downstream end portion 66. When the dispensing port 54 of the nozzle 23e moves from the standby position Pe to the processing position Qb, the length of the upstream end portion 62 of the pipe 61e is constant. When the dispensing port 54 of the nozzle 23e moves from the standby position Pe to the processing position Qb, the length of the upstream portion 63 of the pipe 61e decreases. When the dispensing port 54 of the nozzle 23e moves from the standby position Pe to the processing position Qb, the length of the first bent portion 64 of the pipe 61e is substantially constant. When the dispensing port 54 of the nozzle 23e moves from the standby position Pe to the processing position Qb, the length of the downstream portion 65 of the pipe 61e increases. When the dispensing port 54 of the nozzle 23e moves from the standby position Pe to the processing position Qb, the length of the downstream end portion 66 of the pipe 61e is constant. When the dispensing port 54 of the nozzle 23e moves from the standby position Pe to the processing position Qb, the decrease amount in the length of the upstream portion 63 of the pipe 61e is substantially equal to the increase amount in the length of the downstream portion 65 of the pipe 61e.

Here, it is assumed that the length of the pipe 61e is known. The position of the upstream end portion 62 is assumed to be known. The position of the first bent portion 64 of the pipe 61e is limited to the virtual plane Ke. Even when the dispensing port 54 of the nozzle 23e moves from the standby position Pe to the processing position Qb, the position of the first bent portion 64 of the pipe 61e is limited to the virtual plane Ke. Under these conditions, a theoretical relationship is obtained. The theoretical relationship is a theoretical relationship between the position of the dispensing port 54 of the nozzle 23e and the position of the nozzle 23e about the rotation axis E with respect to the arm 73.

First, the theoretical position of the first bent portion 64 of the pipe 61e is calculated on the basis of the position of the dispensing port 54 of the nozzle 23e. That is, the theoretical position of the first bent portion 64 of the pipe 61e is determined by the position of the dispensing port 54 of the nozzle 23e. For example, the theoretical position of the first bent portion 64 of the pipe 61eP when the dispensing port 54 of the nozzle 23e is located at the standby position Pe is calculated. For example, the theoretical position of the first bent portion 64 of the pipe 61eR when the dispensing port 54 of the nozzle 23e is located at the intermediate position Re is calculated. For example, the theoretical position of the first bent portion 64 of the pipe 61eQb when the dispensing port 54 of the nozzle 23e is located at the processing position Qb is calculated.

Next, the theoretical orientation of the connection portion 55 of the nozzle 23e is acquired on the basis of the position of the dispensing port 54 of the nozzle 23e and the theoretical position of the first bent portion 64 of the pipe 61e. Here, the theoretical position of the first bent portion 64 of the pipe 61e is determined by the position of the dispensing port 54 of the nozzle 23e. Therefore, the theoretical orientation of the connection portion 55 of the nozzle 23e is determined by the position of the dispensing port 54 of the nozzle 23e. The theoretical orientation of the connection portion 55 of the nozzle 23e is an orientation from the position of the dispensing port 54 toward the theoretical position of the first bent portion 64.

Refer to FIG. 16B. The theoretical orientation of the connection portion 55 of the nozzle 23eR is, for example, an angle θeR. The angle θeR is a theoretical orientation of the connection portion 55 of the nozzle 23e when the dispensing port 54 of the nozzle 23e is located at the intermediate position Re. Specifically, the angle θeR is an angle between the virtual plane Ke and a virtual plane MeR. The virtual plane MeR includes the intermediate position Re and includes the first bent portion 64 of the pipe 61eR. The virtual plane MeR is vertical.

The theoretical orientation of the connection portion 55 of the nozzle 23eQb is, for example, an angle θeQb. The angle θeQb is a theoretical orientation of the connection portion 55 of the nozzle 23e when the dispensing port 54 of the nozzle 23e is located at the processing position Qb. The angle θeQb is an angle between the virtual plane Ke and a virtual plane MeQb. The virtual plane MeQb includes the processing position Qb and includes the first bent portion 64 of the pipe 61eQb. The virtual plane MeQb is vertical.

Moreover, the theoretical position of the nozzle 23e about the rotation axis E with respect to the arm 73 is obtained on the basis of the theoretical orientation of the connection portion 55 of the nozzle 23e and the position of the arm 73. That is, the theoretical position of the nozzle 23e about the rotation axis E with respect to the arm 73 is determined by the position of the dispensing port 54 of the nozzle 23e, and the position of the arm 73.

In summary, when the position of the dispensing port 54 of the nozzle 23e and the position of the arm 73 are given, the theoretical relationship is obtained. As described above, the theoretical relationship is the theoretical relationship between the position of the dispensing port 54 of the nozzle 23e and the position of the nozzle 23e about the rotation axis E with respect to the arm 73.

Therefore, the controller 8 may control the nozzle rotation drive section 91 on the basis of the position of the dispensing port 54 of the nozzle 23e, and the position of the arm 73. The controller 8 may control the position of the nozzle 23e about the rotation axis E with respect to the arm 73 on the basis of the position of the dispensing port 54 of the nozzle 23e, and the position of the arm 73.

As described above, the position of the dispensing port 54 of the nozzle 23e and the position of the arm 73 are given by the operation of the arm drive section 81. Therefore, the controller 8 may acquire the position of the dispensing port 54 of the nozzle 23e and the position of the arm 73 on the basis of the operation of the arm drive section 81.

It is easy to obtain the position of the nozzle 23e about the rotation axis E with respect to the arm 73 on the basis of the theoretical relationship. Therefore, the controller 8 may have, for example, relationship information. For example, the nozzle conveyance information described above may include the relationship information.

The relationship information defines the theoretical relationship. Specifically, the relationship information defines the theoretical relationship between the position of the dispensing port 54 of the selection nozzle 23S and the position of the selection nozzle 23S about the rotation axis E with respect to the arm 73. The relationship information defines, for example, a relationship between the position of the dispensing port 54 of the nozzle 23e and the theoretical position of the nozzle 23e about the rotation axis E with respect to the arm 73. Similarly, the relationship information defines a relationship between the positions of the dispensing ports 54 of the nozzles 23a to 23d and 23f to 23j and the positions of the nozzles 23a to 23d and 23f to 23j about the rotation axis E with respect to the arm 73.

The controller 8 may control the nozzle rotation drive section 91 on the basis of the relationship information. The controller 8 may control the position of the selection nozzle 23S about the rotation axis E with respect to the arm 73 on the basis of the relationship information. For example, the controller 8 may control the nozzle rotation drive section 91 on the basis of the relationship information, the position of the dispensing port 54 of the nozzle 23e, and the position of the arm 73. For example, the controller 8 may control the position of the selection nozzle 23S about the rotation axis E with respect to the arm 73 on the basis of the relationship information, the position of the dispensing port 54 of the nozzle 23e, and the position of the arm 73. For example, the controller 8 may acquire the position of the dispensing port 54 of the nozzle 23e and the position of the arm 73 on the basis of the operation of the arm drive section 81.

For example, when the substrate processing apparatus 1 processes the substrate W, the controller 8 may control the nozzle rotation drive section 91 on the basis of the relationship information.

For example, before the substrate processing apparatus 1 processes the substrate W, the controller 8 may control the nozzle rotation drive section 91 on the basis of the relationship information. When the operator adjusts or repairs the substrate processing apparatus 1, the controller 8 may control the nozzle rotation drive section 91 on the basis of the relationship information.

When the operator adjusts or repairs the nozzle rotation drive section 91, the controller 8 may control the nozzle rotation drive section 91 on the basis of the relationship information. When the operator determines the operation of the nozzle rotation drive section 91, the operator may use the relationship information. When the operator determines the operation of the nozzle rotation drive section 91, the operator may correct the relationship information. Here, determining the operation of the nozzle rotation drive section 91 is also called teaching of the nozzle rotation drive section 91.

### <3-2. Second operation example>

Refer to FIG. 10. In the second operation example, the nozzle 23e is moved between the nozzle standby section 59 and the substrate holder 22a. In the second operation example, the nozzle 23e is the selection nozzle 23S. In the second operation example, the pipe 61e is the pipe 61 connected to the selection nozzle 23S. In the second operation example, the virtual plane Ke is the selection virtual plane KS.

The second operation example is similar to the first operation example. Therefore, the second operation example will be briefly described.

The nozzle 23e is located in the nozzle standby section 59. The dispensing port 54 of the nozzle 23e is located at the standby position Pe.

The arm drive section 81 moves the arm 73 to the nozzle standby section 59. Then, the nozzle holder 71 holds the nozzle 23e.

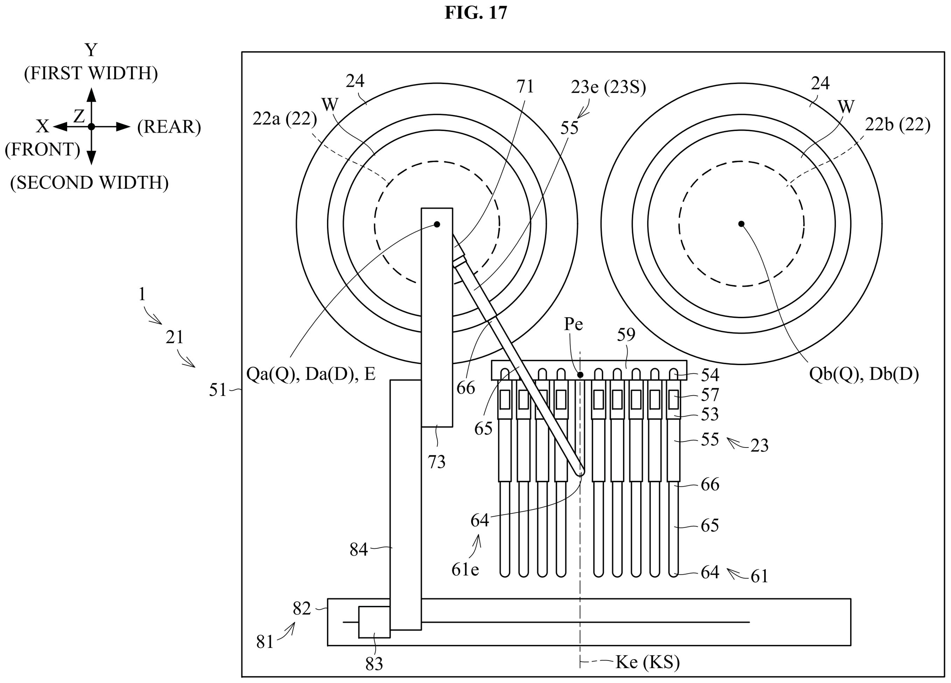

FIG. 17 is a plan view of the coating processing unit 21. The arm drive section 81 moves the arm 73 from the nozzle standby section 59 to the substrate holder 22a. The arm drive section 81 moves the nozzle holder 71 from the nozzle standby section 59 to the substrate holder 22a. The arm drive section 81 moves the nozzle 23e from the nozzle standby section 59 to the substrate holder 22a. The arm drive section 81 moves the dispensing port 54 of the nozzle 23e from the standby position Pe to the processing position Qa.

Moreover, the nozzle rotation drive section 91 rotates the nozzle 23e about the rotation axis E with respect to the arm 73.

Thereafter, the dispensing port 54 of the nozzle 23e stops at the processing position Qa. The dispensing port 54 of the nozzle 23e dispenses the processing solution from the processing position Qa.

Refer to FIG. 12. FIG. 12 illustrates a nozzle 23eQa, a pipe 61eQa, and an arm 73Qa with broken lines. The nozzle 23eQa is the nozzle 23e including the dispensing port 54 located at the processing position Qa. In other words, the nozzle 23e when the dispensing port 54 of the nozzle 23e is located at the processing position Qa is referred to as "nozzle 23eQa". The pipe 61eQa is the pipe 61e connected to the nozzle 23eQa. In other words, the pipe 61e when the nozzle 23e is the nozzle 23eQa is referred to as "pipe 6leQa". The arm 73Qa is the arm 73 that supports the nozzle 23eQa. In other words, the arm 73 that supports the nozzle 23e when the nozzle 23e is the nozzle 23eQa is referred to as "arm 73Qa".

The orientation of the connection portion 55 of the nozzle 23eQa is different from the orientation of the connection portion 55 of the nozzle 23eP.

The orientation of the downstream end portion 66 of the pipe 61eQa is different from the orientation of the downstream end portion 66 of the pipe 61eP.

The relative position of the connection portion 55 of the nozzle 23eQa with respect to the arm 73Qa is different from the relative position of the connection portion 55 of the nozzle 23eP with respect to the arm 73P.

The relative position of the downstream end portion 66 of the pipe 61eQa with respect to the arm 73Qa is different from the relative position of the downstream end portion 66 of the pipe 61eP with respect to the arm 73P.

The orientation of the connection portion 55 of the nozzle 23eQa is different from the orientation of the connection portion 55 of the nozzle 23eQb.

The orientation of the downstream end portion 66 of the pipe 61eQa is different from the orientation of the downstream end portion 66 of the pipe 61eQb.

The relative position of the connection portion 55 of the nozzle 23eQa with respect to the arm 73Qa is different from the relative position of the connection portion 55 of the nozzle 23eQb with respect to the arm 73Qb.

The relative position of the downstream end portion 66 of the pipe 61eQa with respect to the arm 73Qa is different from the relative position of the downstream end portion 66 of the pipe 61eQb with respect to the arm 73Qb.

### <3-3. Third operation example>

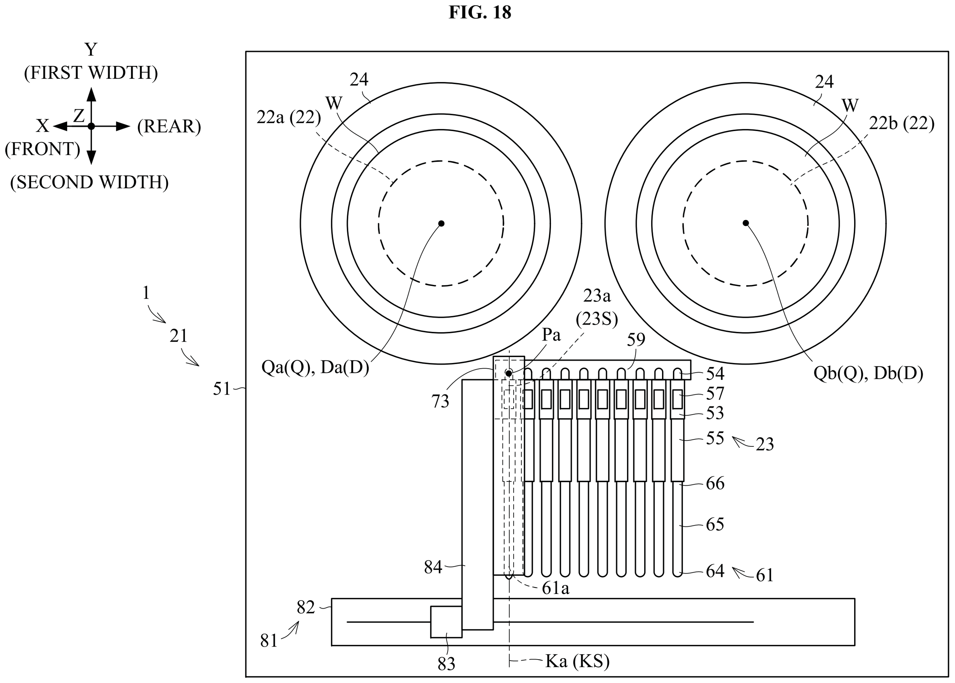

FIG. 18 is a plan view of the coating processing unit 21. In the third operation example, the nozzle 23a is moved between the nozzle standby section 59 and the substrate holder 22b. In the third operation example, the nozzle 23a is the selection nozzle 23S. In the third operation example, the pipe 61a is the pipe 61 connected to the selection nozzle 23S. In the third operation example, the virtual plane Ka is the selection virtual plane KS.

The third operation example is similar to the first operation example and the second operation example. Therefore, the third operation example will be briefly described.

The nozzle 23a is located in the nozzle standby section 59. The dispensing port 54 of the nozzle 23a is located at the standby position Pa.

The arm drive section 81 moves the arm 73 to the nozzle standby section 59. Then, the nozzle holder 71 holds the nozzle 23a.

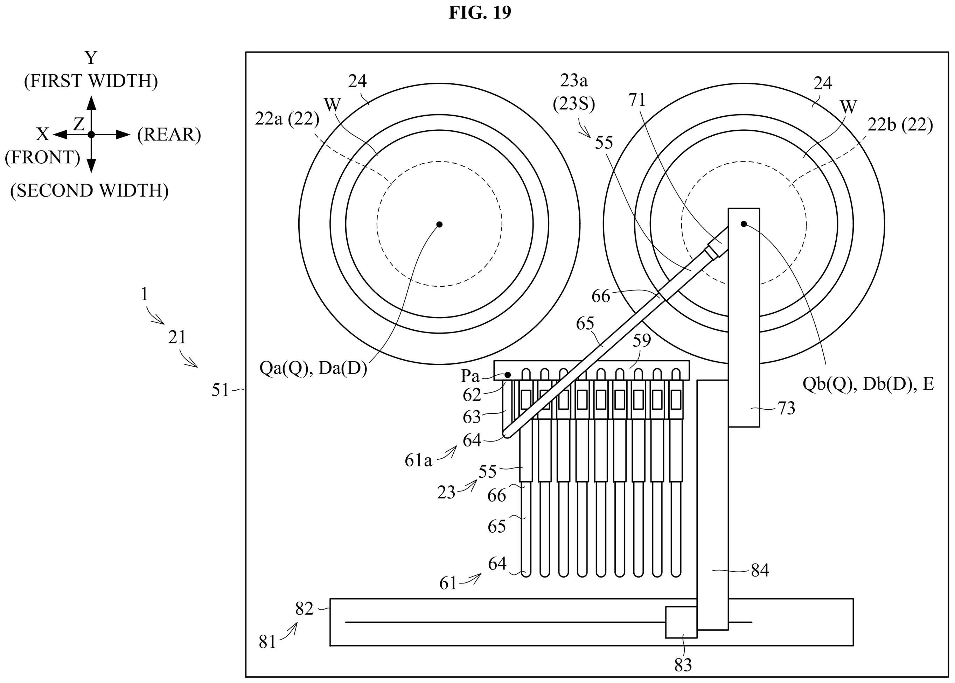

FIG. 19 is a plan view of the coating processing unit 21. The arm drive section 81 moves the arm 73 from the nozzle standby section 59 to the substrate holder 22b. The arm drive section 81 moves the nozzle holder 71 from the nozzle standby section 59 to the substrate holder 22b. The arm drive section 81 moves the nozzle 23a from the nozzle standby section 59 to the substrate holder 22b. The arm drive section 81 moves the dispensing port 54 of the nozzle 23a from the standby position Pa to the processing position Qb.

Moreover, the nozzle rotation drive section 91 rotates the nozzle 23a about the rotation axis E with respect to the arm 73.

Thereafter, the dispensing port 54 of the nozzle 23a stops at the processing position Qb. The dispensing port 54 of the nozzle 23a dispenses the processing solution from the processing position Qb.

Refer to FIGS. 11 and 19. The position of the arm 73 when the dispensing port 54 of the nozzle 23a is located at the processing position Qb is the same as the position of the arm 73 when the dispensing port 54 of the nozzle 23e is located at the processing position Qb.

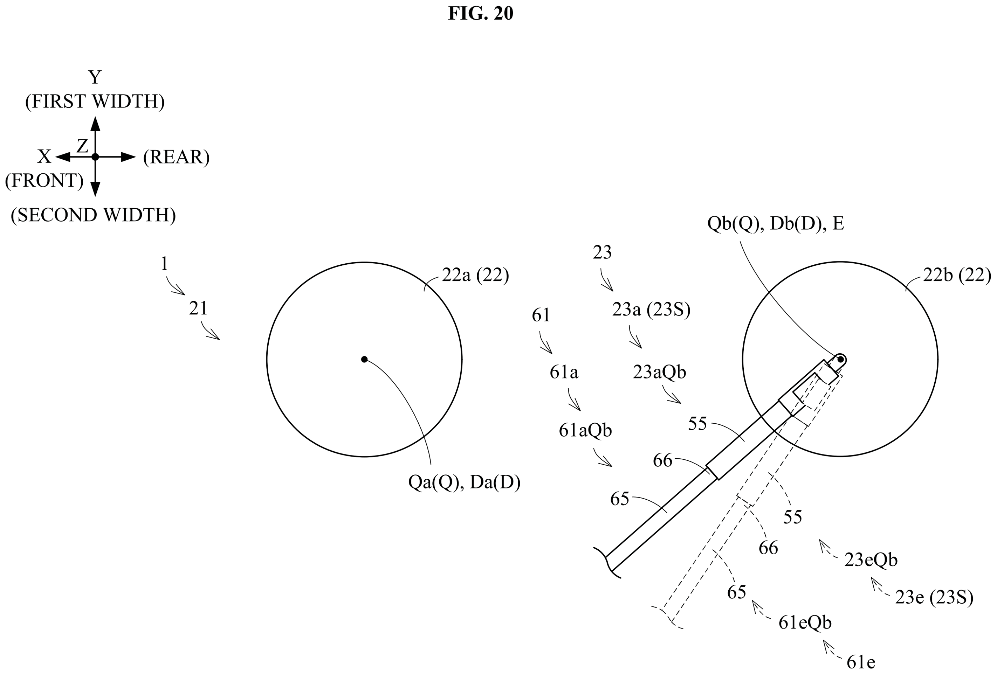

FIG. 20 is a plan view of the coating processing unit 21. FIG. 20 illustrates a nozzle 23aQb and a pipe 61aQb with solid lines. The nozzle 23aQb is the nozzle 23a including the dispensing port 54 located at the processing position Qb. In other words, the nozzle 23a when the dispensing port 54 of the nozzle 23a is located at the processing position Qb is referred to as "nozzle 23aQb". The pipe 61aQb is the pipe 61a connected to the nozzle 23aQb. In other words, the pipe 61a when the nozzle 23a is the nozzle 23aQb is referred to as "pipe 61aQb".

FIG. 20 further illustrates the nozzle 23eQb and the pipe 61eQb with broken lines.

The orientation of the connection portion 55 of the nozzle 23aQb is different from the orientation of the connection portion 55 of the nozzle 23eQb.

The orientation of the downstream end portion 66 of the pipe 61aQb is different from the orientation of the downstream end portion 66 of the pipe 61eQb.

The relative position of the connection portion 55 of the nozzle 23aQb with respect to the arm 73 is different from the relative position of the connection portion 55 of the nozzle 23eQb with respect to the arm 73.

The relative position of the downstream end portion 66 of the pipe 61aQb with respect to the arm 73 is different from the relative position of the downstream end portion 66 of the pipe 61eQb with respect to the arm 73.

### <4. Effects of embodiment>

The substrate processing apparatus 1 includes the substrate holder 22. The substrate holder 22 holds the substrate W in a horizontal attitude. The substrate processing apparatus 1 includes the plurality of nozzles 23 and the plurality of pipes 61. Each of the plurality of nozzles 23 dispenses the processing solution. Each of the plurality of pipes 61 is connected to the nozzle 23. The substrate processing apparatus 1 includes the nozzle holder 71, the arm 73, and the arm drive section 81. The nozzle holder 71 holds any one of the nozzles 23. The arm 73 is coupled to the nozzle holder 71. The arm drive section 81 moves the arm 73. The arm drive section 81 moves the nozzle 23 held by the nozzle holder 71. Each of the nozzles 23 includes the dispensing port 54 and the connection portion 55. The dispensing port 54 dispenses the processing solution. Each connection portion 55 is connected to the pipe 61. Each of the pipes 61 includes a downstream end portion 66. The downstream end portion 66 is connected to the connection portion 55. Each of the pipes 61 has flexibility. Thus, it is easy for the downstream end portion 66 to move integrally with the nozzle 23 connected to the downstream end portion 66.

The nozzle 23 held by the nozzle holder 71 is defined as the selection nozzle 23S. The arm drive section 81 moves the dispensing port 54 of the selection nozzle 23S to the processing position Q. The processing position Q is for dispensing the processing solution to the substrate W held by the substrate holder 22. Therefore, it is easy for the selection nozzle 23S to dispense the processing solution to the substrate W held by the substrate holder 22.

The selection nozzle 23S is rotatable about the rotation axis E with respect to the arm 73. Therefore, the connection portion 55 of the selection nozzle 23S is rotatable about the rotation axis E with respect to the arm 73. The downstream end portion 66 of the pipe 61 connected to the selection nozzle 23S is rotatable about the rotation axis E with respect to the arm 73. Accordingly, it is easy to adjust the orientation of the connection portion 55 of the selection nozzle 23S. It is easy to adjust the orientation of the downstream end portion 66 of the pipe 61 connected to the selection nozzle 23S. Therefore, it is easy to simplify the path of the pipe 61 connected to the selection nozzle 23S. As a result, it is easy to reduce the load applied to the pipe 61.

The rotation axis E passes through the dispensing port 54 of the selection nozzle 23S. Therefore, even when the selection nozzle 23S rotates about the rotation axis E with respect to the arm 73, the position of the dispensing port 54 of the selection nozzle 23S does not change. Accordingly, the rotation of the selection nozzle 23S about the rotation axis E with respect to the arm 73 does not make it difficult to adjust the position of the dispensing port 54 of the selection nozzle 23S. Therefore, even if the selection nozzle 23S is rotatable about the rotation axis E with respect to the arm 73, it is easy to adjust the position of the dispensing port 54 of the selection nozzle 23S.

In summary, the substrate processing apparatus 1 simplifies the path of the pipe 61. More specifically, the substrate processing apparatus 1 facilitates adjustment of the position of the dispensing port 54 of the nozzle 23 and simplifies the path of the pipe 61.

The rotation of the selection nozzle 23S about the rotation axis E with respect to the arm 73 is independent of the movement of the arm 73 by the arm drive section 81. Therefore, even if the arm 73 does not move, the orientation of the connection portion 55 of the selection nozzle 23S can be changed. In other words, even in a state where the arm 73 is stationary, the orientation of the connection portion 55 of the selection nozzle 23S can be changed.

The rotation axis E extends in the vertical direction Z. Therefore, it is easier to simplify the path of the pipe 61 connected to the selection nozzle 23S.

The processing position Q is disposed above the substrate W held by the substrate holder 22. The dispensing port 54 dispenses the processing solution downward. Therefore, it is easy for the selection nozzle 23S to dispense the processing solution to the substrate W held by the substrate holder 22.

The connection portion 55 of the selection nozzle 23S extends in the radial direction of the rotation axis E. Therefore, it is easier to adjust the orientation of the connection portion 55 of the selection nozzle 23S. Accordingly, it is easier to adjust the orientation of the downstream end portion 66 of the pipe 61 connected to the selection nozzle 23S. Therefore, it is easier to simplify the path of the pipe 61 connected to the selection nozzle 23S.

The downstream end portion 66 of the pipe 61 connected to the selection nozzle 23S extends in the radial direction of the rotation axis E. Accordingly, it is easier to adjust the orientation of the downstream end portion 66 of the pipe 61 connected to the selection nozzle 23S. Therefore, it is easier to simplify the path of the pipe 61 connected to the selection nozzle 23S.

The nozzle holder 71 is rotatable about the rotation axis E with respect to the arm 73. Therefore, it is easy for the selection nozzle 23S to rotate about the rotation axis E with respect to the arm 73.

The substrate processing apparatus 1 includes the nozzle rotation drive section 91. The nozzle rotation drive section 91 rotates the selection nozzle 23S about the rotation axis E with respect to the arm 73. Therefore, it is easy for the selection nozzle 23S to rotate about the rotation axis E with respect to the arm 73. Moreover, it is easy to adjust the position of the selection nozzle 23S about the rotation axis E with respect to the arm 73. Accordingly, it is easy to adjust the relative position of the connection portion 55 of the selection nozzle 23S with respect to the arm 73. Therefore, it is easy to adjust the orientation of the connection portion 55 of the selection nozzle 23S.

The nozzle rotation drive section 91 rotates the nozzle holder 71 about the rotation axis E with respect to the arm 73. Therefore, it is easy for the nozzle rotation drive section 91 to rotate the selection nozzle 23S about the rotation axis E with respect to the arm 73.

The substrate processing apparatus 1 includes the controller 8. The controller 8 controls the nozzle rotation drive section 91. Therefore, it is easy for the nozzle rotation drive section 91 to rotate the selection nozzle 23S about the rotation axis E with respect to the arm 73.

The controller 8 has the relationship information. The relationship information defines a relationship between the position of the dispensing port 54 of the selection nozzle 23S and the position of the selection nozzle 23S about the rotation axis E with respect to the arm 73. The controller 8 controls the nozzle rotation drive section 91 on the basis of the relationship information. Therefore, it is easy for the controller 8 to control the nozzle rotation drive section 91.

The orientation of the connection portion 55 of the nozzle 23aQb is different from the orientation of the connection portion 55 of the nozzle 23eQb. Specifically, the orientation of the connection portion 55 of the nozzle 23a when the dispensing port 54 of the nozzle 23a is located at the processing position Qb is different from the orientation of the connection portion 55 of the nozzle 23e when the dispensing port 54 of the nozzle 23e is located at the processing position Qb. Therefore, when the dispensing port 54 of the nozzle 23a is located at the processing position Qb, it is easy to simplify the path of the pipe 61a connected to the nozzle 23a. When the dispensing port 54 of the nozzle 23e is located at the processing position Qb, it is easy to simplify the path of the pipe 61e connected to the nozzle 23e.

The orientation of the downstream end portion 66 of the pipe 61aQb is different from the orientation of the downstream end portion 66 of the pipe 61eQb. Specifically, the orientation of the downstream end portion 66 of the pipe 61a when the dispensing port 54 of the nozzle 23a is located at the processing position Qb is different from the orientation of the downstream end portion 66 of the pipe 61e when the dispensing port 54 of the nozzle 23e is located at the processing position Qb. Therefore, when the dispensing port 54 of the nozzle 23a is located at the processing position Qb, it is easy to simplify the path of the pipe 61a connected to the nozzle 23a. When the dispensing port 54 of the nozzle 23e is located at the processing position Qb, it is easy to simplify the path of the pipe 61e connected to the nozzle 23e.

The selection nozzle 23S rotates about the rotation axis E with respect to the arm 73 so that the number of bent portions included in the pipe 61 connected to the selection nozzle 23S is one. Therefore, it is easy to simplify the path of the pipe 61 connected to the selection nozzle 23S.

While the arm drive section 81 moves the selection nozzle 23S, the selection nozzle 23S rotates about the rotation axis E with respect to the arm 73. Therefore, when the arm drive section 81 moves the selection nozzle 23S, it is easy to keep the path of the pipe 61 connected to the selection nozzle 23S simple.

Each of the pipes 61 includes the upstream end portion 62 in addition to the downstream end portion 66. The upstream end portion 62 is fixed at a predetermined position. Therefore, the substrate processing apparatus 1 does not include a mechanism for moving the upstream end portion 62. Accordingly, it is easy to downsize the coating processing unit 21. For example, it is easy to reduce the length of the coating processing unit 21 in the vertical direction Z. Therefore, it is easy to downsize the substrate processing apparatus 1.

Each of the pipes 61 includes the upstream portion 63, the first bent portion 64, and the downstream portion 65. The upstream portion 63 extends from the upstream end portion 62. The upstream portion 63 extends linearly. The first bent portion 64 is bent from the upstream portion 63. The downstream portion 65 extends from the first bent portion 64 to the downstream end portion 66. The downstream portion 65 extends linearly. Therefore, each of the pipes 61 is bent only at the first bent portion 64. In other words, each of the pipes 61 is not bent except at the first bent portion 64. Each of the pipes 61 extends linearly at a portion other than the first bent portion 64. Accordingly, it is easy to limit the number of bent portions of the pipe 61 to one.

The selection nozzle 23S rotates about the rotation axis E with respect to the arm 73 so that the connection portion 55 of the selection nozzle 23S is directed to the first bent portion 64 of the pipe 61 connected to the selection nozzle 23S. Therefore, it is easy for the downstream portion 65 of the pipe 61 connected to the selection nozzle 23S to extend from the downstream end portion 66 toward the first bent portion 64. Accordingly, it is easy for the downstream portion 65 of the pipe 61 connected to the selection nozzle 23S to linearly extend from the downstream end portion 66 to the first bent portion 64. In other words, it is easy for the entire downstream portion 65 of the pipe 61 connected to the selection nozzle 23S to extend linearly.

The selection nozzle 23S rotates about the rotation axis E with respect to the arm 73 so that the downstream end portion 66 of the pipe 61 connected to the selection nozzle 23S is directed to the first bent portion 64 of the pipe 61 connected to the selection nozzle 23S. Therefore, it is easy for the downstream portion 65 of the pipe 61 connected to the selection nozzle 23S to extend from the downstream end portion 66 toward the first bent portion 64. Accordingly, it is easy for the downstream portion 65 of the pipe 61 connected to the selection nozzle 23S to linearly extend from the downstream end portion 66 to the first bent portion 64.

Each upstream end portion 62 extends in the width direction Y in plan view. The plurality of upstream portions 63 is arranged in the front-rear direction X. The first bent portion 64 is bent vertically. The selection virtual plane KS is a virtual plane. The selection virtual plane KS includes the upstream end portion 62 of the pipe 61 connected to the selection nozzle 23S. The selection virtual plane KS is vertical. The processing position Q is shifted in the front-rear direction X from the selection virtual plane KS in plan view. In other words, the processing position Q is not located on the selection virtual plane KS in plan view. Therefore, the processing position Q is shifted in the front-rear direction X from the upstream end portion 62 of the pipe 61 connected to the selection nozzle 23S. Accordingly, when the dispensing port 54 of the selection nozzle 23S is located at the processing position Q, the downstream end portion 66 of the pipe 61 connected to the selection nozzle 23S is shifted in the front-rear direction X from the upstream end portion 62 of the pipe 61 connected to the selection nozzle 23S.

Here, the selection nozzle 23S rotates about the rotation axis E with respect to the arm 73 so that the first bent portion 64 of the pipe 61 connected to the selection nozzle 23S is suppressed from being shifted from the selection virtual plane KS in the front-rear direction X in plan view. Therefore, it is easy to prevent interference between the plurality of pipes 61. For example, it is easy to prevent the first bent portion 64 of the pipe 61 connected to the selection nozzle 23S from coming into contact with the pipe 61 connected to the nozzle 23 other than the selection nozzle 23S. For example, it is easy to prevent contact between the pipes 61 adjacent in the front-rear direction X.

When the arm drive section 81 moves the selection nozzle 23S, the selection nozzle 23S rotates about the rotation axis E with respect to the arm 73 so that the first bent portion 64 of the pipe 61 connected to the selection nozzle 23S moves on the selection virtual plane KS in plan view. Therefore, it is easy to prevent interference between the plurality of pipes 61.

The substrate processing apparatus 1 includes the nozzle standby section 59. The nozzle 23 stands by in the nozzle standby section 59. The arm drive section 81 moves the selection nozzle 23S to the nozzle standby section 59. The relative position of the connection portion 55 of the selection nozzle 23S with respect to the arm 73 when the selection nozzle 23S stands by in the nozzle standby section 59 is different from the relative position of the connection portion 55 of the selection nozzle 23S with respect to the arm 73 when the dispensing port 54 of the selection nozzle 23S is located at the processing position Q. For example, the relative position of the connection portion 55 of the nozzle 23eP with respect to the arm 73P is different from the relative position of the connection portion 55 of the nozzle 23eQb with respect to the arm 73Qb. Therefore, when the selection nozzle 23S stands by in the nozzle standby section 59, it is easy to simplify the path of the pipe 61 connected to the selection nozzle 23S. When the dispensing port 54 of the selection nozzle 23S is located at the processing position Q, it is easy to simplify the path of the pipe 61 connected to the selection nozzle 23S.

The arm drive section 81 moves the dispensing port 54 of the nozzle 23e along the virtual line Le in plan view. The virtual line Le is a virtual straight line connecting the standby position Pe and the processing position Qb. The standby position Pe is a position of the dispensing port 54 of the nozzle 23e that stands by in the nozzle standby section 59. Therefore, the dispensing port 54 of the nozzle 23e linearly moves between the standby position Pe and the processing position Qb in plan view. Accordingly, it is easy to simplify the path along which the nozzle 23e moves. Therefore, when the nozzle 23e moves, it is easy to keep the path of the pipe 61e connected to the nozzle 23e simple.

The substrate processing apparatus 1 includes the substrate holders 22a and 22b. Each of the substrate holders 22a and 22b holds the substrate W in a horizontal attitude. The arm drive section 81 moves the dispensing port 54 of the selection nozzle 23S to the processing position Qa for dispensing the processing solution to the substrate W held by the substrate holder 22a. The arm drive section 81 moves the dispensing port 54 of the selection nozzle 23S to the processing position Qb for dispensing the processing solution to the substrate W held by the substrate holder 22b. The processing position Qa is for dispensing the processing solution to the substrate W held by the substrate holder 22a. The processing position Qb is for dispensing the processing solution to the substrate W held by the substrate holder 22b. Therefore, the nozzle 23 is used not only for the processing of the substrate W on the substrate holder 22a but also for the processing of the substrate W on the substrate holder 22b. Accordingly, it is easy to reduce the number of nozzles 23 included in the substrate processing apparatus 1. Similarly, the nozzle holder 71, the arm 73, and the arm drive section 81 are used not only for the processing of the substrate W on the substrate holder 22a but also for the processing of the substrate W on the substrate holder 22b. Accordingly, it is easy to reduce the number of nozzle holders 71, the number of arms 73, and the number of arm drive sections 81. Therefore, it is easy to downsize the substrate processing apparatus 1.

The orientation of the connection portion 55 of the nozzle 23eQb is different from the orientation of the connection portion 55 of the nozzle 23eQa. Specifically, the orientation of the connection portion 55 of the nozzle 23e when the dispensing port 54 of the nozzle 23e is located at the processing position Qb is different from the orientation of the connection portion 55 of the nozzle 23e when the dispensing port 54 of the nozzle 23e is located at the processing position Qa. Therefore, when the dispensing port 54 of the nozzle 23e is located at the processing position Qa, it is easy to simplify the path of the pipe 61e connected to the nozzle 23e. When the dispensing port 54 of the nozzle 23e is located at the processing position Qb, it is easy to simplify the path of the pipe 61e connected to the nozzle 23e.

### <5. Modified embodiments>

The present invention is not limited to the embodiment, and can be modified and implemented as follows.
(1) The nozzle rotation drive section 91 may be omitted. The selection nozzle 23S may be freely rotatable about the rotation axis E with respect to the arm 73. For example, the nozzle holder 71 may be freely rotatable about the rotation axis E with respect to the arm 73. According to the present modified embodiment, the connection portion 55 of the selection nozzle 23S is rotated about the rotation axis E with respect to the arm 73 by the pipe 61 connected to the selection nozzle 23S. In other words, the connection portion 55 of the selection nozzle 23S allows the path of the pipe 61 connected to the selection nozzle 23S to be simplified. Accordingly, it is easy to simplify the path of the pipe 61 connected to the selection nozzle 23S.
(2) The engagement portion 57 may be rotatable with respect to the nozzle 23. According to the present modified embodiment, it is easy for the selection nozzle 23S to freely rotate about the rotation axis E with respect to the arm 73.

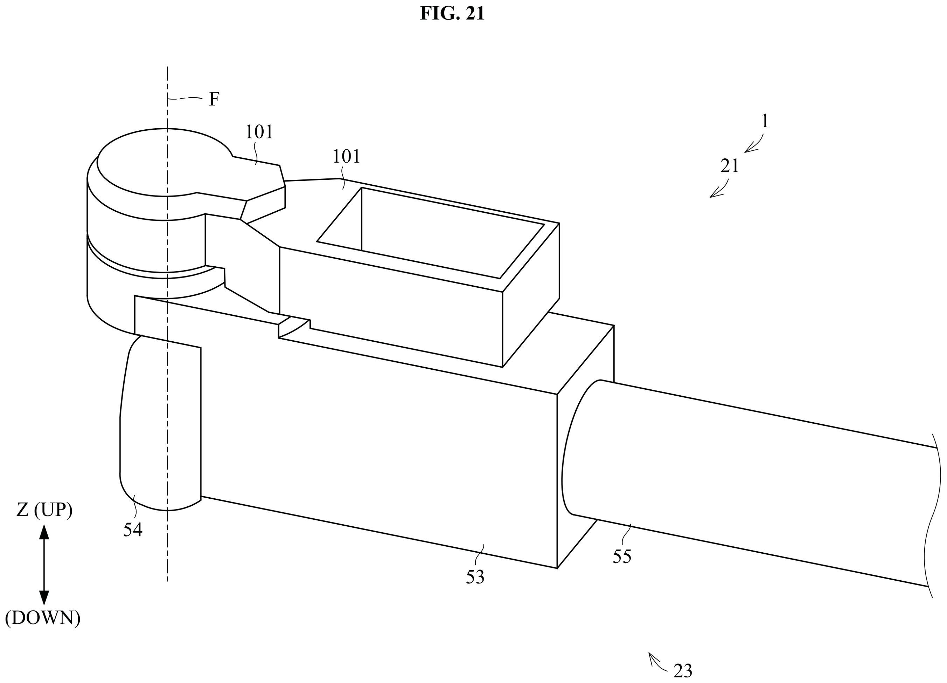

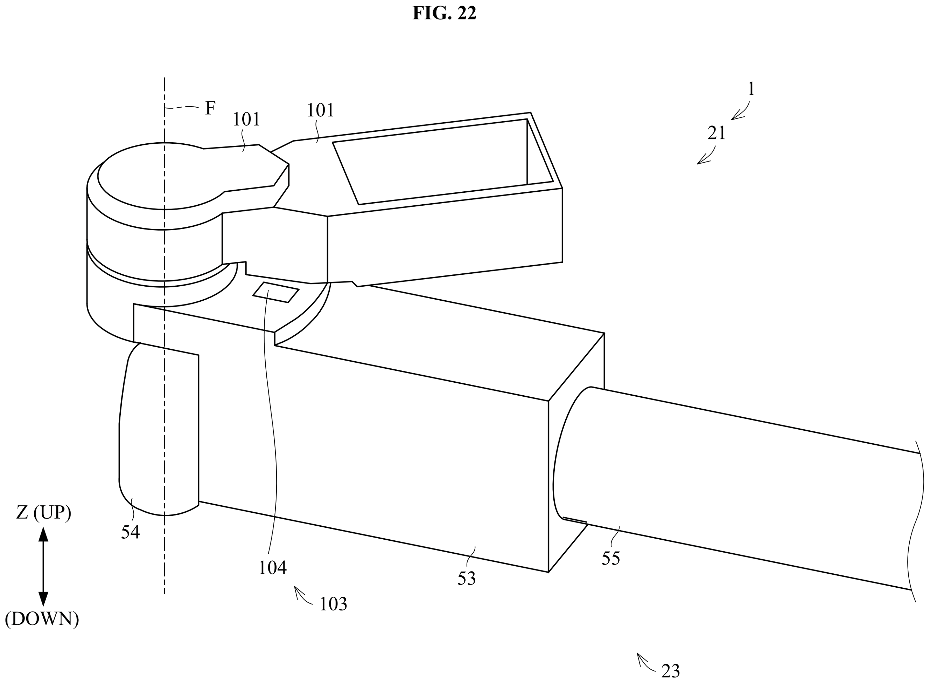

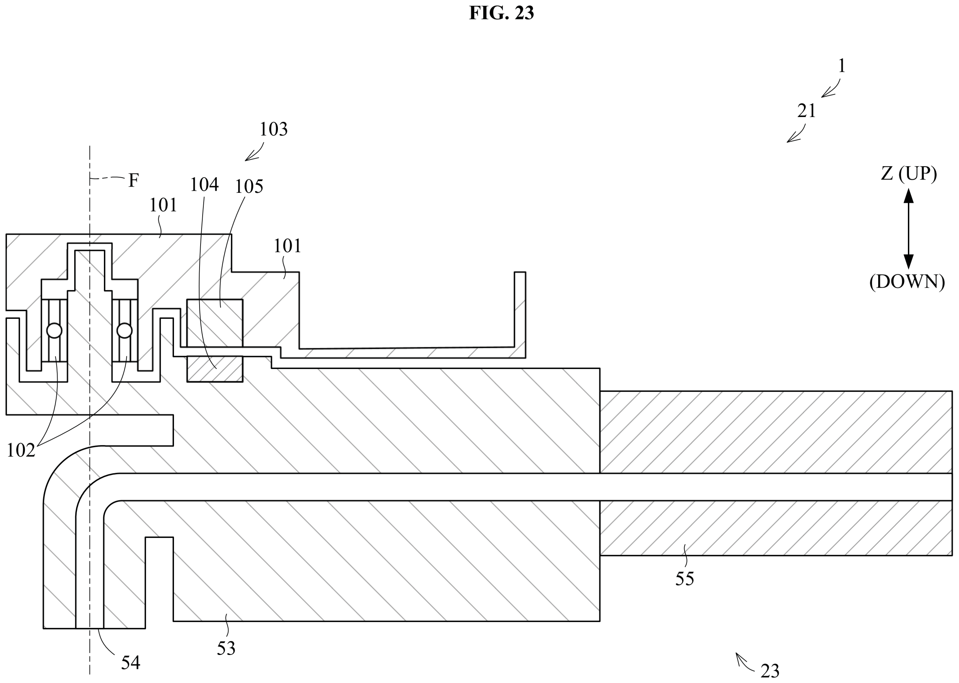

FIGS. 21 and 22 are perspective views of a nozzle and an engagement portion according to a modified embodiment, respectively. FIG. 23 is a cross-sectional view of the nozzle and the engagement portion of the modified embodiment. Note that the same configurations as those of the embodiment are denoted by the same reference signs, and a detailed description thereof will be omitted.

The coating processing unit 21 includes a nozzle 23 and an engagement portion 101. The engagement portion 101 is coupled to the nozzle 23. The engagement portion 101 is coupled to the nozzle 23 via a bearing 102. For example, the engagement portion 101 is coupled to a nozzle body 53 via a bearing 102. Therefore, the engagement portion 101 is rotatable with respect to the nozzle 23.

The engagement portion 101 is rotatable about a nozzle axis F with respect to the nozzle 23.

The nozzle axis F is defined by the nozzle 23. The nozzle axis F passes through the dispensing port 54 of the nozzle 23. The dispensing port 54 of the nozzle 23 is located on the nozzle axis F.

The nozzle axis F extends in the vertical direction Z.

When the engagement portion 101 is engaged with the nozzle holder 71, the nozzle 23 coupled to the engagement portion 101 is the selection nozzle 23S. When the engagement portion 101 is engaged with the nozzle holder 71, the nozzle axis F of the nozzle 23 coupled to the engagement portion 101 is the rotation axis E.

When the nozzle holder 71 is engaged with the engagement portion 101, the selection nozzle 23S is rotatable about the rotation axis E with respect to the nozzle holder 71. When the nozzle holder 71 holds the selection nozzle 23S, the selection nozzle 23S is rotatable about the rotation axis E with respect to the arm 73.

In the present modified embodiment, the nozzle holder 71 may be fixed to the arm 73. In the present modified embodiment, the nozzle holder 71 may be non-rotatable with respect to the arm 73.

(2-1) In the present modified embodiment, a coating processing unit 21 may further include a nozzle rotation drive section. Although not illustrated, the nozzle rotation drive section rotates the nozzle 23 coupled to the engagement portion 101 with respect to the engagement portion 101. The nozzle rotation drive section is attached to at least one of the nozzle 23 and the engagement portion 101.

(2-2) In the present modified embodiment, the engagement portion 101 may be freely rotatable with respect to the nozzle 23 coupled to the engagement portion 101. In other words, the nozzle 23 may be freely rotatable with respect to the engagement portion 101 coupled to the nozzle 23. When the nozzle holder 71 is engaged with the engagement portion 101, the selection nozzle 23S may be freely rotatable about the rotation axis E with respect to the nozzle holder 71. When the nozzle holder 71 is engaged with the engagement portion 101, the selection nozzle 23S may be freely rotatable about the rotation axis E with respect to the arm 73.

(3) The coating processing unit 21 may further include the biasing portion.

(3-1) Although not illustrated, the coating processing unit 21 of the embodiment may further include the biasing portion. The biasing portion biases the selection nozzle 23S to the initial position. The biasing portion is, for example, a first magnet and a second magnet. The first magnet is attached to the selection nozzle 23S or an element fixed to the selection nozzle 23S. The element fixed to the selection nozzle 23S is, for example, at least one of the nozzle holder 71 and the engagement portion 101. The second magnet is attached to the arm 73 or an element fixed to the arm 73. The first magnet and the second magnet attract each other. One of the first magnet and the second magnet has an N pole, and the other of the first magnet and the second magnet has an S pole. As a result, the selection nozzle 23S is biased to the initial position with respect to the arm 73.

Here, the initial position is one position of the selection nozzle 23S about the rotation axis E with respect to the arm 73. For example, when the dispensing port 54 of the selection nozzle 23S is located at the standby position P and the selection nozzle 23S is at the initial position, the selection nozzle 23S is appropriately supported by the nozzle standby section 59. For example, when the dispensing port 54 of the selection nozzle 23S is located at the standby position P and the selection nozzle 23S is at the initial position, the connection portion 55 of the selection nozzle 23S extends from the nozzle body 53 in the second width direction.

According to the present modified embodiment, it is easy for the nozzle holder 71 to hold the nozzle 23 in the nozzle standby section 59. It is easy for the nozzle holder 71 to place the selection nozzle 23S on the nozzle standby section 59.

(3-2) The coating processing unit 21 of the modified embodiment described in the above (2) may include a biasing portion 103.

Refer to FIGS. 22 and 23. The biasing portion 103 biases the nozzle 23 to an initial position. The biasing portion 103 is, for example, a first magnet 104 and a second magnet 105. The first magnet 104 is attached to the nozzle 23. The second magnet 105 is attached to the engagement portion 101. One of the first magnet 104 and the second magnet 105 has an N pole, and the other of the first magnet 104 and the second magnet 105 has an S pole. The first magnet 104 and the second magnet 105 attract each other.

Here, the initial position is one position of the nozzle 23 about the nozzle axis F with respect to the engagement portion 101. For example, when the nozzle 23 is held by the nozzle holder 71, the dispensing port 54 of the selection nozzle 23S is located at the standby position P, and the nozzle 23 is at the initial position, the nozzle 23 is appropriately supported by the nozzle standby section 59. For example, when the nozzle 23 is held by the nozzle holder 71, the dispensing port 54 of the selection nozzle 23S is located at the standby position P, and the nozzle 23 is at the initial position, the connection portion 55 of the nozzle 23 extends from the nozzle body 53 in the second width direction.

According to the present modified embodiment, it is easy for the nozzle holder 71 to engage with the engagement portion 101 coupled to the nozzle 23 in the nozzle standby section 59. Accordingly, it is easy for the nozzle holder 71 to hold the nozzle 23 in the nozzle standby section 59. It is easy for the nozzle holder 71 to place the selection nozzle 23S on the nozzle standby section 59.

(4) The coating processing unit 21 may include a partition that prevents interference between the pipes 61.

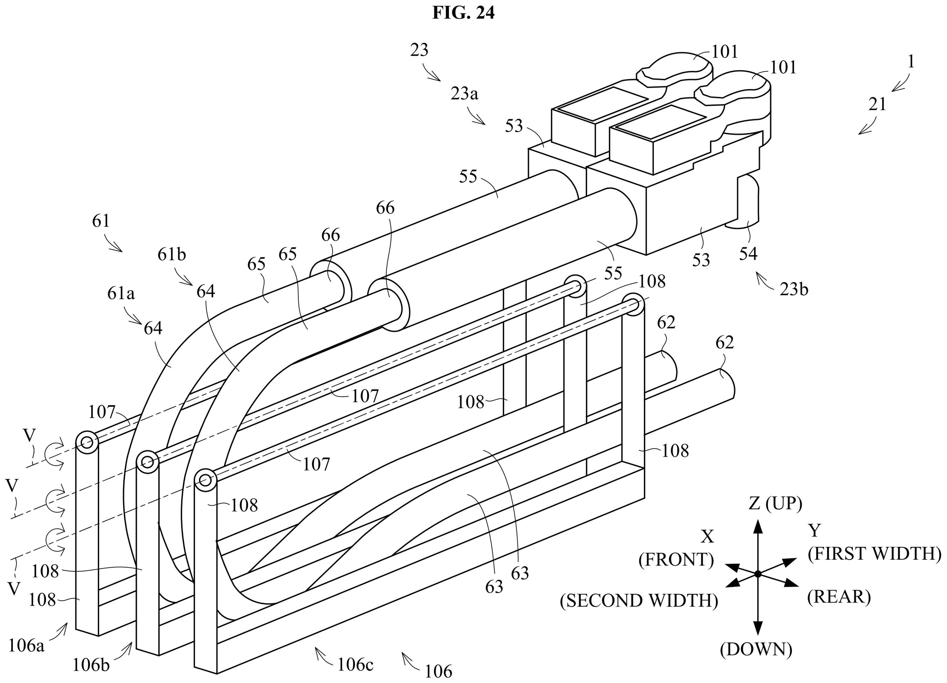

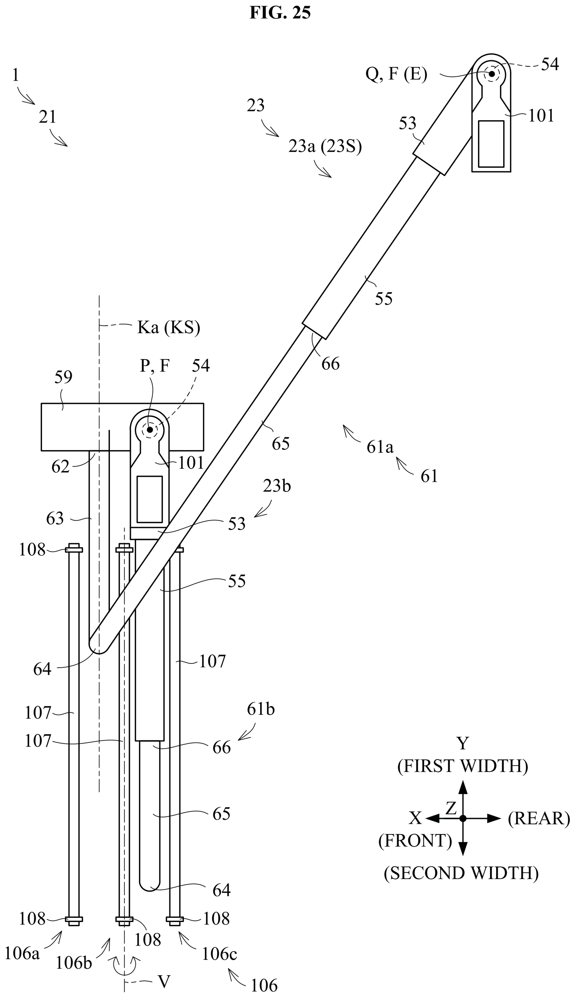

FIG. 24 is a perspective view of a coating processing unit 21 of a modified embodiment. FIG. 25 is a plan view of a coating processing unit 21 of a modified embodiment. Note that the same configurations as those of the embodiment are denoted by the same reference signs, and a detailed description thereof will be omitted.

The coating processing unit 21 includes two nozzles 23, two pipes 61, and two engagement portions 101. Each of the pipes 61 is connected to each of the nozzles 23. The engagement portion 101 is coupled to the nozzle 23. The nozzle 23 includes the nozzle body 53 and the connection portion 55. The nozzle body 53 includes the dispensing port 54.

In a case where the nozzles 23 are distinguished, the nozzles 23 are referred to as nozzles 23a and 23b. In a case where the pipes 61 are distinguished, the pipes 61 are referred to as pipes 61a and 61b. The pipe 61a is connected to the nozzle 23a. The pipe 61b is connected to the nozzle 23b.

The coating processing unit 21 includes a plurality of partitions 106. The partitions 106 are disposed on both sides of the pipe 61. The pipe 61a is disposed between the two partitions 106. The pipe 61b is disposed between the two partitions 106. In a case where the partitions 106 are distinguished, the partitions 106 are referred to as partitions 106a, 106b, and 106c, respectively.

The partition 106 includes a bar 107. The bar 107 extends in the width direction Y. The bar 107 has a round bar shape.

The bar 107 extends from the upstream portion 63 to the first bent portion 64. The bar 107 extends from the downstream end portion 66 to the first bent portion 64.

The bar 107 is disposed at a position higher than the upstream end portion 62. The bar 107 is disposed at a position higher than the upstream portion 63. The bar 107 is disposed at the same height position as the first bent portion 64. The bar 107 is disposed at a position lower than the downstream portion 65. The bar 107 is disposed at a position lower than the downstream end portion 66.

The partition 106 includes a stand 108. The stand 108 supports the bar 107.

The bar 107 is rotatable about an axis V of the bar 107 with respect to the stand 108. The axis V passes through the center of the bar 107. The axis V extends in the width direction Y. For example, the bar 107 is supported by the stand 108 via a bearing (not illustrated).

Refer to FIG. 25. In FIG. 25, for convenience, illustration of the nozzle holder 71, the arm 73, and the arm drive section 81 is omitted. The nozzle 23b stands by in the nozzle standby section 59. The dispensing port 54 of the nozzle 23b is located at the standby position P.

The pipe 61b is disposed between the partition 106b and the partition 106c. The entire pipe 61b is disposed between the partition 106b and the partition 106c in the front-rear direction X. The pipe 61b is not in contact with the partition 106. The pipe 61b is separated from the partition 106.

The nozzle 23a is held by the nozzle holder 71. The nozzle 23a is the selection nozzle 23S. The virtual plane Ka is the selection virtual plane KS.

The dispensing port 54 of the nozzle 23a is located at the processing position Q.

The motion of the pipe 61a is regulated by the partition 106a and the partition 106b. In particular, the motion of the first bent portion 64 of the pipe 61a is regulated by the partition 106a and the partition 106b. For example, at least a part of the first bent portion 64 of the pipe 61a is limited to a range between the partition 106a and the partition 106b. For example, the lower portion of the first bent portion 64 of the pipe 61a is limited to a range between the partition 106a and the partition 106b in the front-rear direction X.

The pipe 61a is in contact with the partition 106b. The pipe 61a is not in contact with the partitions 106a and 106c.

Specifically, the first bent portion 64 of the pipe 61a is in contact with the partition 106b. The first bent portion 64 of the pipe 61a is in contact with the bar 107 of the partition 106b. The first bent portion 64 of the pipe 61a is not in contact with a stand 108 of the partition 106b.

Therefore, the first bent portion 64 of the pipe 61a is not excessively shifted in the front-rear direction X from the virtual plane Ka in plan view. At least a part of the first bent portion 64 of the pipe 61a is located on the virtual plane Ka in plan view. Accordingly, the pipe 61a is not in contact with the pipe 61b.

When the pipe 61a moves in a state where the pipe 61a is in contact with the bar 107 of the partition 106b, the bar 107 of the partition 106b rotates with respect to the stand 108. Therefore, the bar 107 is not rubbed against the pipe 61a. The partition 106 is not rubbed against the pipe 61a. Accordingly, even when the pipe 61a is in contact with the bar 107 of the partition 106b, the pipe 61a moves smoothly. The partition 106 does not damage the pipe 61a. It is easy to prevent the pipe 61 from being damaged. It is easy to protect the pipe 61. Moreover, even when the pipe 61 and the partition 106 come into contact with each other, it is easy to prevent generation of particles.

(5) The processing position Q does not have to be located on the substrate rotation axis D. The processing position Qa does not have to be located on the substrate rotation axis Da. The processing position Qb does not have to be located on the substrate rotation axis Db.

(6) The number of the substrate holders 22 may be appropriately changed. For example, the number of substrate holders 22 included in the coating processing unit 21 may be one. For example, the number of substrate holders 22 included in the coating processing unit 21 may be more than two.

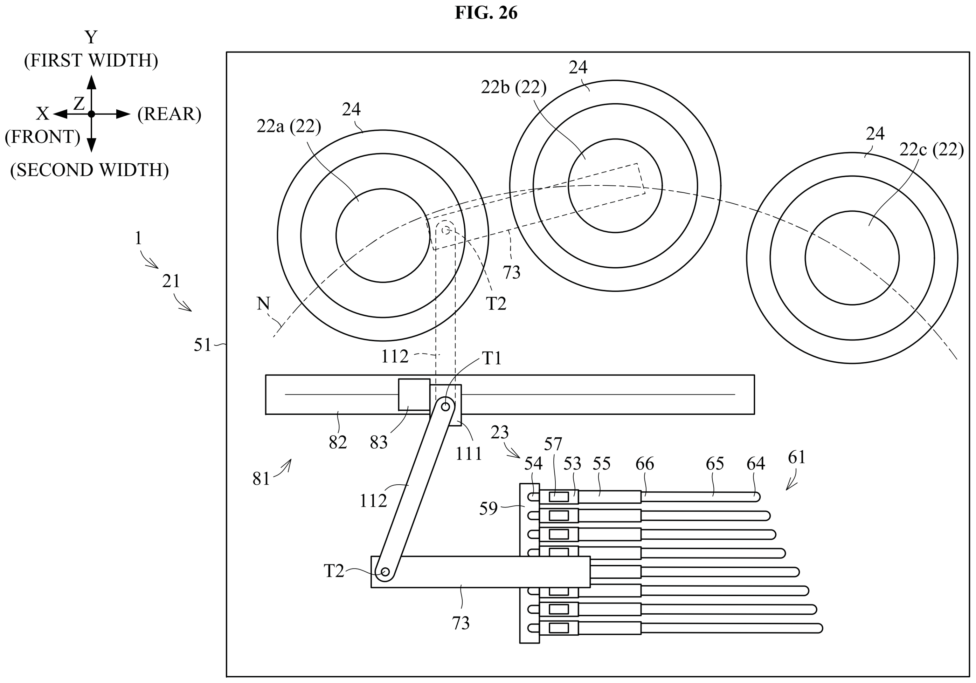

FIG. 26 is a plan view of a coating processing unit 21 of the modified embodiment. Note that the same configurations as those of the embodiment are denoted by the same reference signs, and a detailed description thereof will be omitted. The coating processing unit 21 includes three substrate holders 22. Specifically, the coating processing unit 21 includes substrate holders 22a, 22b, and 22c. Each nozzle 23 dispenses the processing solution to the substrate W held by the substrate holder 22a, the substrate W held by the substrate holder 22b, and the substrate W held by the substrate holder 22c.

(7) The direction in which the substrate holders 22 are arranged may be appropriately changed. For example, the plurality of substrate holders 22 may be arranged in the width direction Y.

In a case where the number of the substrate holders 22 is more than two, the plurality of substrate holders 22 may be disposed on a straight line. In a case where the number of the substrate holders 22 is more than two, the plurality of substrate holders 22 may be disposed on a curve.

Refer to FIG. 26. The substrate holders 22a, 22b, and 22c are disposed on the curve N.

(8) The direction in which the plurality of nozzles 23 is arranged in the nozzle standby section 59 may be appropriately changed. For example, the plurality of nozzles 23 may be arranged on a curve in the nozzle standby section 59. For example, the plurality of nozzles 23 may be arranged on a V-shaped line in the nozzle standby section 59.

Refer to FIG. 26. In FIG. 26, the plurality of nozzles 23 stands by in the nozzle standby section 59. The plurality of nozzles 23 is aligned in the width direction Y in the nozzle standby section 59.

(9) The direction in which the pipe 61 extends may be appropriately changed.

Refer to FIG. 26. Each of the pipes 61 extends in the front-rear direction X. When the nozzle 23 stands by in the nozzle standby section 59, each of the pipes 61 extends in the front-rear direction X.

(10) The direction in which the plurality of pipes 61 is arranged may be appropriately changed.

Refer to FIG. 26. The plurality of pipes 61 is arranged in the width direction Y. When the nozzle 23 stands by in the nozzle standby section 59, the plurality of pipes 61 is arranged in the width direction Y.

(11) The lengths of the plurality of pipes 61 may be different from each other.

Refer to FIG. 26. The length of one pipe 61 is different from the lengths of the other pipes 61.

(12) The position of the base 82 may be appropriately changed. For example, the base 82 may be disposed at a position higher than the arm 73. For example, the base 82 may be fixed to a top plate of the housing 51. For example, the base 82 may be disposed above the horizontal movement section 83. The horizontal movement section 83 may extend downward from the base 82.

Refer to FIG. 26. The base 82 is disposed between the substrate holder 22 and the nozzle standby section 59. The substrate holder 22, the base 82, and the nozzle standby section 59 are arranged in this order in the width direction Y.

(13) The configuration of the arm drive section 81 may be changed as appropriate.

Refer to FIG. 26. The arm drive section 81 includes the base 82, the horizontal movement section 83, the vertical movement section 111, and a link 112. The horizontal movement section 83 is supported by the base 82. The horizontal movement section 83 moves in the front-rear direction X with respect to the base 82. The vertical movement section 111 is supported by the horizontal movement section 83. The vertical movement section 111 moves in the vertical direction Z with respect to the horizontal movement section 83. The link 112 is supported by the vertical movement section 111. The link 112 rotates about an axis T1 with respect to the vertical movement section 111. The axis T1 extends in the vertical direction Z. The link 112 supports the arm 73. The arm 73 rotates about an axis T2 with respect to the link 112. The link 112 rotates the arm 73 about the axis T2 with respect to the link 112. The axis T2 extends in the vertical direction Z.

In the above-described modified embodiment, the horizontal movement section 83 may be fixedly installed. For example, the horizontal movement section 83 may be fixed to the housing 51. The horizontal movement section 83 may be immovable in the front-rear direction X with respect to the base 82. Alternatively, the base 82 may be omitted. The horizontal movement section 83 may be supported by the housing 51.

(14) In the embodiment and each modified embodiment described in the above (1) to (13), each configuration may be appropriately changed by further replacing or combining each configuration with a configuration of another modified embodiment.

The present invention may be embodied in other specific forms without departing from the spirit or essential attributes thereof and, accordingly, reference should be made to the appended claims, rather than to the foregoing specification, as indicating the scope of the invention.

### Reference Signs List

1: Substrate processing apparatus
8: Controller
21: Coating processing unit
22: Substrate holder
22a, 22b: Substrate holder (first substrate holder, second substrate holder)
23, 23a-23j: Nozzle
23a, 23e: Nozzle (first nozzle, second nozzle)
23eP: Nozzle including dispensing port located at standby position
23eQb: Nozzle including dispensing port located at processing position
23eR: Nozzle including dispensing port located at intermediate position
23S: Selection nozzle
53: Nozzle body
54: Dispensing port
55: Connection portion
59: Nozzle standby section
61, 61a-61j: Pipe
61a, 61e: Pipe (first pipe, second pipe)
62: Upstream end portion
63: Upstream portion
64: First bent portion
65: Downstream portion
66: Downstream end portion
71: Nozzle holder
73: Arm
81: Arm drive section
57, 101: Engagement portion
103: Biasing portion
91: Nozzle rotation drive section
E: Rotation axis
F: Nozzle axis
Ka, Ke: Virtual plane (selection virtual plane)
KS: Selection virtual plane
Le: Virtual line (first virtual line)
P: Standby position
Q: Processing position
Qa, Qb: Processing position (first processing position, second processing position)
W: Substrate
X: Front-rear direction (second direction)
Y: Width direction (first direction)
Z: Vertical direction

## Claims

1. A substrate processing apparatus comprising:
a first substrate holder configured to hold a substrate in a horizontal attitude;
a plurality of nozzles configured to dispense a processing solution;
a plurality of pipes connected to the nozzles;
a nozzle holder configured to hold any one nozzle of the nozzles;
an arm coupled to the nozzle holder; and
an arm drive section configured to move the arm to move the nozzle held by the nozzle holder,
wherein each of the nozzles includes:
a dispensing port configured to dispense a processing solution; and
a connection portion connected to the pipes,
each of the pipes includes
a downstream end portion connected to the connection portion,
each of the pipes has flexibility,
the nozzle held by the nozzle holder is defined as a selection nozzle,
the arm drive section moves the dispensing port of the selection nozzle to a first processing position for dispensing a processing solution to a substrate held by the first substrate holder,
the selection nozzle is rotatable about a rotation axis with respect to the arm, and
the rotation axis passes through the dispensing port of the selection nozzle.

2. The substrate processing apparatus according to claim 1, wherein rotation of the selection nozzle about the rotation axis with respect to the arm is independent of movement of the arm by the arm drive section.

3. The substrate processing apparatus according to claim 1, wherein the rotation axis extends in a vertical direction.

4. The substrate processing apparatus according to claim 1, wherein
the first processing position is disposed above a substrate held by the first substrate holder, and
the dispensing port dispenses a processing solution downward.

5. The substrate processing apparatus according to claim 1, wherein the connection portion of the selection nozzle extends in a radial direction of the rotation axis.

6. The substrate processing apparatus according to claim 1, wherein the downstream end portion of the pipe connected to the selection nozzle extends in a radial direction of the rotation axis.

7. The substrate processing apparatus according to claim 1, wherein the nozzle holder is rotatable about the rotation axis with respect to the arm.

8. The substrate processing apparatus according to claim 1, further comprising a nozzle rotation drive section configured to rotate the selection nozzle about the rotation axis with respect to the arm.

9. The substrate processing apparatus according to claim 8, wherein the nozzle rotation drive section rotates the nozzle holder about the rotation axis with respect to the arm.

10. The substrate processing apparatus according to claim 8, further comprising a controller configured to control the nozzle rotation drive section.

11. The substrate processing apparatus according to claim 1, wherein
one of the nozzles is defined as a first nozzle,
another one of the nozzles is defined as a second nozzle, and
an orientation of the connection portion of the first nozzle when the dispensing port of the first nozzle is located at the first processing position is different from an orientation of the connection portion of the second nozzle when the dispensing port of the second nozzle is located at the first processing position.

12. The substrate processing apparatus according to claim 1, wherein the selection nozzle rotates about the rotation axis with respect to the arm so that a number of bent portions included in the pipe connected to the selection nozzle is one.

13. The substrate processing apparatus according to claim 1, wherein while the arm drive section moves the selection nozzle, the selection nozzle rotates about the rotation axis with respect to the arm.

14. The substrate processing apparatus according to claim 1, wherein
each of the pipes includes:
an upstream end portion fixed at a predetermined position;
an upstream portion linearly extending from the upstream end portion in plan view;
a first bent portion bent from the upstream portion; and
a downstream portion linearly extending from the first bent portion to the downstream end portion in plan view.

15. The substrate processing apparatus according to claim 14, wherein the selection nozzle rotates about the rotation axis with respect to the arm so that the connection portion of the selection nozzle is directed to the first bent portion of the pipe connected to the selection nozzle.

16. The substrate processing apparatus according to claim 14, wherein
each of a plurality of the upstream end portions of the plurality of pipes extends in a first direction,
a plurality of the upstream portions of the plurality of pipes is arranged in a second direction,
the first direction is horizontal,
the second direction is horizontal and orthogonal to the first direction,
the first bent portion is bent vertically,
a vertical virtual plane including the upstream end portion of the pipe connected to the selection nozzle is defined as a selection virtual plane,
the first processing position is shifted from the selection virtual plane in the second direction in plan view, and
the selection nozzle rotates about the rotation axis with respect to the arm so that the first bent portion of the pipe connected to the selection nozzle is suppressed from being shifted from the selection virtual plane in the second direction in plan view.

17. The substrate processing apparatus according to claim 16, wherein the selection nozzle rotates about the rotation axis with respect to the arm so that the first bent portion of the pipe connected to the selection nozzle moves on the selection virtual plane in plan view when the arm drive section moves the selection nozzle.

18. The substrate processing apparatus according to claim 1, further comprising
a nozzle standby section configured to cause the plurality of nozzles to stand by,
wherein the arm drive section moves the selection nozzle to the nozzle standby section, and
a relative position of the connection portion of the selection nozzle with respect to the arm when the selection nozzle stands by in the nozzle standby section is different from a relative position of the connection portion of the selection nozzle with respect to the arm when the dispensing port of the selection nozzle is located at the first processing position.

19. The substrate processing apparatus according to claim 1, further comprising
a second substrate holder configured to hold a substrate in a horizontal attitude,
wherein the arm drive section moves the dispensing port of the selection nozzle to a second processing position for dispensing a processing solution to the substrate held by the second substrate holder.

20. The substrate processing apparatus according to claim 19, wherein
one of the nozzles is defined as a first nozzle, and
an orientation of the connection portion of the first nozzle when the dispensing port of the first nozzle is located at the second processing position is different from an orientation of the connection portion of the first nozzle when the dispensing port of the first nozzle is located at the first processing position.
